(19) Europäisches Patentamt
European Patent Office
Office européen des brevets

(11) EP 2 112 701 A1

(12) EUROPEAN PATENT APPLICATION

(43) Date of publication:
**28.10.2009 Bulletin 2009/44**

(51) Int Cl.:
***H01L 51/00*** *(2006.01)* *H01G 9/20* *(2006.01)*

(21) Application number: **08007771.2**

(22) Date of filing: **22.04.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Sony Corporation**
**Tokyo 108-0075 (JP)**

(72) Inventors:
- **Fuhrmann, Gerda**
  **70327 Stuttgart (DE)**
- **Nelles, Gabriele**
  **70327 Stuttgart (DE)**
- **Bamedi Zilai, Ameneh**
  **70327 Stuttgart (DE)**
- **Rosselli, Silvia**
  **70327 Stuttgart (DE)**
- **Obermaier, Markus**
  **70327 Stuttgart (DE)**

(74) Representative: **Appelt, Christian W.**
**Forrester & Boehmert**
**Pettenkoferstrasse 20-22**
**80336 München (DE)**

# (54) Preparation of high-quality sensitizer dye for dye-sensitized solar cells

(57) The present invention relates to a method of purifying a dye for use in dye-sensitized solar cells (DSSC), comprising the step of purifying a soluble form of said dye by reversed-phase chromatography, preferably using HPLC.
Furthermore, methods for verifying the purity of the sensitizer dyes are disclosed.

EP 2 112 701 A1

## Description

The present invention relates to a method for the preparation applicable on large scale of sensitizer dyes conventionally used in dye-sensitized solar cells. Furthermore, methods for verifying the purity of the sensitizer dyes are disclosed.

One type of photovoltaic cells, which have attracted great attention since their first announcement are the so called dye-sensitized solar cells (DSSC).[1] Due to their low production costs and high efficiency the commercial interest and the industrialization of these photovoltaic devices is steadily growing.

DSSC offer high energy-conversion efficiencies at low cost because they use semiconductor materials such as nanocrystalline $TiO_2$ that have less stringent requirements than silicon. Since nanocrystalline $TiO_2$ absorbs little photon energy from the sunlight, molecular dyes are used as sensitizing agents. The structure of the dye includes one or more anchor groups which allow their adsorption or tight coupling with the semiconductor solid. The cell is constructed in sandwich configuration.

The working electrode is the nanoporous $TiO_2$ placed on a conducting support, and the counter electrode is generally platinum also sputtered on a conductive support layer. The operating principle of a DSSC is the following: a light photon enters the cell and transverses it until it is absorbed by the dye molecule. The dye is then promoted into its excited state from where now it is energetically able to inject an electron into the conduction band of the semiconductor, mostly nanoporous $TiO_2$ The electron flows into an external circuit through a load (resistor) such that the energy can be utilized. After this, the electron which now carries less energy enters the cell via the counter electrode. The remaining oxidized dye on the semiconductor surface is reduced back to its original state by the redox couple, generally iodine/iodide couple, completing the circuit.

The efficiency of DSSC is beside others determined by the number of photons collected, and thus by the light absorbed by the dye sensitizer. Therefore, the dye is one of the key components of this kind of solar cells. Polypyridyl complexes of ruthenium, the so called red dye and black dye, have been shown to be the most efficient sensitizers. The chemical name of the red dye is cis-bis(isothiocyanato)bis(2,2'-bipyridyl-4,4'-dicarboxylato)-ruthenium(II). It shows the best performance when employed in form of its bis-tetrabutylammonium salt. The tradename is Ruthenium535-bisTBA or N719 (Dyesol, Australia; Solaronix SA, Switzerland; Kojima-kagaki, Japan). The chemical name of the black dye is tris(isothiocyanato)-(2,2':6',2"-terpyridine-4,4',4"-tricarboxylato)-ruthenium(II). It shows the best performance when employed in form of its tris-tetrabutylammonium salt. The tradename is Ruthenium 620 or N749 (Dyesol, Australia; Solaronix SA, Switzerland; Kojima kagaki, Japan).

Sensitizer dyes are commercially available; however, the purity and quality of the dyes varies depending on the source (company) and even on the batch from one and the same source (company). Therefore, further purification steps are needed, since the quality of the sensitizer has a direct influence on the efficiency of the solar cells. This is costly and very time consuming.

Nazeeruddin *et al.* describe a method for the preparation of the red dye and its bis-tetrabutylammonium salt which is the active form of the sensitizer in DSSC.[2] However, this method presents many problems for a production on a large scale. A typical procedure is extremely time-consuming because it includes several synthetic steps (see Figure 5). The preparation of the red dye includes two synthetic steps and to prepare its bis-tetrabutylammonium salt which additionally two more steps are needed. Beside these synthetic efforts, also a large number of purification steps, such as precipitation, centrifugation or filtration and dissolution steps of intermediates and product are required. Further, in order to get the sensitizer dye in a sufficient purity, as a final purification step, chromatography on a Sephadex LH-20 column is used. This method is characterized by a low resolution so that some impurities and especially isomers of the red dye cannot be removed completely. Further, the use of methanol as an eluent during this purification methods limits the up-scaling and automation of this process due to the low solubility of the dyes in methanol. Last but not least, the method is not cost efficient, since Sephadex LH-20 material is very expensive.

In WO 02/092569A1 a method for purifying organic ligands and dye materials containing carboxylic acid groups on a large scale is described (Ref. 3, see below). In principle, the synthesis is the similar multi-step method described by Nazeeruddin (Ref.2). Different and advanced is the purification process by dissolution-reprecipitation. The dissolution under basic conditions of the crude material containing carboxylic acid groups is made in the presence of inorganic oxids such as $SiO_2$ or $TiO_2$ of micron and sub-micron particle sizes. This results in adsorption of the material to the inorganic oxide surface. After separation of the metallic oxide with the attached material by filtration, the material is dissoluted from the surface and reprecipitate by addition of an acid. However, even if this method is more efficient in removing by-products and impurities, dyes of high-purity cannot be obtained. Impurities which also can contain carboxylic acid groups, e.g. isomers of the red dye, not reacted ligands, will not be removed by this method. Further purification steps would have to be performed.

References:

1. a) O'Regan B. and Grätzel M. Nature 353 (1991) 737: b) Grätzel et. al. WO 91/16719A; WO 94/04497;
2. a) Nazeeruddin M.K. et al., J. Am. Chem. Soc., 115 (1993) 6382-6290; b) Nazeeruddin et al., Inorg. Chem., 28 (1999), 6298-6305.
3. Koplick A., Berloz M.; WO 02/092569A1


Accordingly, it was an object of the present invention to provide for a reliable, cost efficient and fast method for preparing sensitizer dyes of high purity and quality for use in DSSCs. Furthermore, this method should be automatable in order to ensure the reliable processing of DSSCs in production lines with high efficiencies.

The objects of the present invention are solved by a method of purifying a dye for use in dye-sensitized solar cells (DSSC), comprising the steps:

(i) providing a dye which is useful as sensitizer in a dye-sensitized solar cell,
(ii) converting said dye into a soluble form, preferably a water-soluble form, of said dye by adding $NR_4$-OH, wherein R is H or alkyl, preferably $C_4$-$C_{12}$-alkyl, more preferably butyl,
(iii) purifying said soluble form of said dye by reversed-phase chromatography, preferably using HPLC,
(iv) isolating said dye by acid precipitation,
(v) dissolving said dye resulting from step (iv) in a solvent to provide a dye-solution and adjusting the pH of said dye solution to a value in the range of from 4 to 10.

In one embodiment, said dye has a number "a" of acidic groups HA per molecule that may release a proton or, in their deprotonated form $A^-$, may accept a proton, and in step (ii) an amount of $NR_4$-OH equimolar to "a" is added so as to convert said dye into a soluble, preferably water-soluble, form.

In one embodiment, said solvent is a solvent from which, in the manufacture of a dye-sensitized solar cell (DSSC), adsorption of said dye to a semiconductor layer of said DSSC is carried out.

In one embodiment, said solvent is selected from acetonitrile, a lower alcohol having 1-6 C-atoms, such as methanol, ethanol, propanol, isopropanol, butanol, *t*-butanol, or methoxypropionitrile, dimethylformamide, or any mixture containing these solvents, wherein, preferably, said solvent is a lower alcohol having 1-6 C-atoms, preferably ethanol, and said pH of said dye-solution is adjusted to a range of from 5 to 7, preferably 5.9 to 6.3 and most preferred 6.1 ± 0.5, if said dye solution has a dye concentration in the range from 0.1 mM to 0.5 mM, preferably from 0.2 mM to 0.4 mM, or wherein said solvent is a 1/1 mixture of acetonitrile/t-butanol and said pH of said dye-solution is adjusted to a range of from 7 to 9, preferably, 7.9 to 8.2 and most preferred 8 ± 0.5, if said dye solution has a dye concentration in the range from 0.1 mM to 0.5 mM, preferably from 0.2 mM to 0.4 mM.

In one embodiment, in step (v), adjusting the pH of said dye solution occurs by addition of an appropriate amount of base or acid, wherein, preferably, said base is $NR_4$-OH, R being as defined in claim 1, and wherein said acid is trifluoromethanesulfonic acid, trifluoroacetic acid, nitric acid, acetic acid or sulphuric acid.

In one embodiment, said dye is a metal-complex having one or more aromatic heterocyclic ligands, said ligand containing at least one nitrogen atom, N, which is linked to said metal, wherein, preferably, said metal is ruthenium or osmium, preferably ruthenium.

In one embodiment, said dye is a compound having the formula

$$(NR_4)_m[(HA)_a(A)_b\text{-}N_n]MX_p,$$

with a, b, m, n, p being integers and being selected from 0 - 20, with the proviso that

$$n + p = 6,$$

$$m + 2 = b + p,$$

m being selected from 0-12, preferably 0-4,
$NR_4$ being a tetraalkylammonium or ammonium,

R being H or alkyl, preferably $C_4$ - $C_{12}$, alkyl,
M being a metal selected from ruthenium or osmium, preferably ruthenium,
X being an anion with
p being selected from 0-4, preferably 2 or 3,
HA being an acidic group and
A being a basic group corresponding to said acidic group HA after release of a proton from HA,

with a denoting the total number of acidic groups HA per dye molecule and being in the range of from 1-12, preferably 1-4, and more preferably 1-2,
$[(HA)_a(A)_b\text{-}N_n]$ being said one or more aromatic heterocyclic ligands containing n nitrogen atoms linked to M, n denoting the total number of nitrogen atoms per dye molecule.

In one embodiment, said dye is a pyridyl complex of ruthenium, preferably a polypyridyl complex of ruthenium.

In one embodiment, said acidic group HA is selected from -COOH, $-SO_3H$ and $-PO_3H_2$.

Preferably, said aromatic heterocyclic ligand is a mono- or polycyclic condensed ring system or a system of rings covalently bonded to each other, wherein, optionally, said ring system or rings are substituted with further substituents, such as halogens or functional groups such as OH, $NH_2$, and/or have further groups R' attached, R' being H, alkyl, aryl, alkoxy, NR"2, R" being H or alkyl.

Preferably, said aromatic heterocyclic ligand has a core to which said HA and/or A groups and, optionally, further substituents, as defined in claim 13, are attached, which core is selected from the group comprising

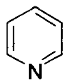
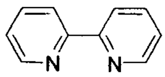
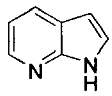
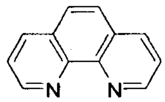

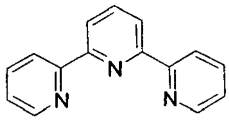
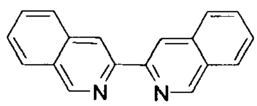
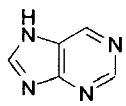

In one embodiment, said anion X, at each occurrence, is independently selected from the group comprising $Cl^-$, $Br^-$, $I^-$, $[CN]^-$, $[NCS]^-$rpreferably being $[NCS]^-$ with N linked to the metal M.

In one embodiment, said dye is cis-bis(isothiocyanato) bis(2,2'-bipyridyl-4,4'-dicarboxylato)-ruthenium(II) ("red dye"), wherein, preferably, in step (ii), 4 equivalents of $NR_4$-OH to the amount of "red dye" is added, R being H or alkyl, preferably $C_4$-$C_{12}$ alkyl.

In another embodiment, said dye is cis-bis (isothiocyanato)bis(2,2'bipyridyl-4,4'-dicarboxylato)-ruthenium(II) bis-tetrabutylammonium ("2TBA-red dye"), wherein, preferably, in step (ii), 2 equivalents of $NR_4$-OH to the amount of "2TBA-red dye" is added, R being H or alkyl, preferably$C_4$-$C_{12}$ alkyl.

In yet another embodiment, said dye is tris(isothiocyanato)-ruthenium(II)-(2,2' : 6',2"-terpyridine -4,4',4"-tricarboxylato) tris-tetrabutylammonium salt ("3TBA-black dye"), wherein, preferably, in step (ii), 1 equivalent of $NR_4$-OH to the amount of "3TBA-black dye" is added, R being H or alkyl, preferably $C_4$-$C_{12}$ alkyl.

The objects of the present invention are also solved by a one-pot method of synthesizing cis-bis(isothiocyanato) bis(2,2'-bipyridyl-4,4'-dicarboxylato)-ruthenium(II) ("red dye") comprising the steps:

a) providing, in any order,
dimeric (p-cymol)-ruthenium(II)chloride and 2,2'-bipyridine-4,4'-dicarboxylic acid,
b) allowing said dimeric (p-cymol)-ruthenium(II)chloride and 2,2'-bipyridine-4,4'-dicarboxylic acid to react in a single reaction mixture,
c) adding a thiocyanate salt to said reaction mixture and allowing said reaction mixture to react to yield red dye.

Preferably, steps b) and c) are performed at a temperature > 100°C and preferably under inert atmosphere and exclusion of light.

Preferably, steps b) and c) are performed at a temperature > 140°C, preferably in the range of from 150°C to 180°C and under inert atmosphere and exclusion of light.

The objects of the present invention are also solved by a dye purified by the method according to any of claims

1-21 or prepared by the method according to any of claims 22-24, and having no impurities, preferably no impurities detectable in an NMR-spectrum.

The objects of the present invention are also solved by a dye purified by the method according to any of claims 1-21 and being characterized by analytical HPLC showing HPLC-purity higher than 99%.

The objects of the present invention are also solved by a dye purified by the method according to any of claims 1-21 and being characterized by a HPLC trace shown hereafter, using the following conditions:

column material: reversed phase, preferably C18 or C8
eluent: mixture of alcohol, such as ethanol or methanol/water or acetonitrile/water at pH 7-11, preferably 9-11

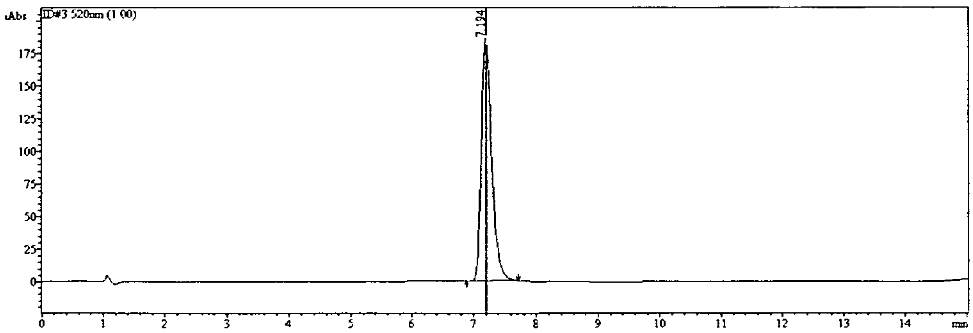


and preferably also by a UV-Vis spectrum represented by:

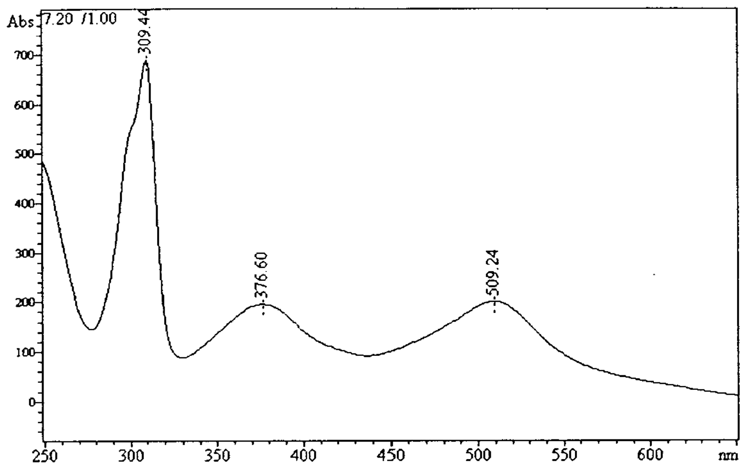


The objects of the present invention are also solved by a solution of a dye purified by the method according to the present invention and having a pH in the range of from 4 to 11, preferably 4 to 10, wherein, preferably, the solvent is ethanol and the pH of said solution at a concentration of 0.3 mM dye is in the range of from 5 to 7, preferably 6.1 ± 0.5.

In another embodiment, the solvent is acetonitrile/t-butanol and the pH of said solution at a concentration of 0.3 mM dye is in the range of from 7 to 9, preferably 8.05 ± 0.5.

The objects of the present invention are also solved by a dye obtained by evaporating the solvent from the solution according to the present invention, wherein, preferably, said evaporation occurs by freeze-drying or rotary evaporation.

The objects of the present invention are also solved by a dye obtained as solid after evaporation according to the present invention.

The objects of the present invention are also solved by a dye-sensitized solar cell produced using the dye according to the present invention, in particular the solid dye obtained after evaporation as outlined above.

The objects of the present invention are also solved by a dye-sensitized solar cell produced using directly the

solution according to the present invention.

Preferably, the dye according to the present invention is a "high-quality sensitizer dye". This term is preferably meant to denote
a sensitizer dye prepared by the method of the present invention
of general formula $(NR_4)_m[(HA)_a(A)_bN_n]MX_p$,
with a, b, m, n, p being integers and

$$n + p = 6$$

$$m+2 = b + p$$

with all of the indices being integral positive numbers and the following meanings:

$(NR_4)$ represents an ammonium or tetraalkylammonium with R being H or an alkyl group, preferably $C_4$-$C_{12}$-alkyls and m being an integer from 0 to 12, preferably 0-4.
M represents ruthenium or osmium.
X represents $Cl^-$,$Br^-$, $I^-$, $CN^-$, $SCN^-$, $NCS^-$, preferably $NCS^-$ with N being linked to the metal , with p being an integer of from 0 to 4, preferably from 2 to 3.
$[(HA)_a(A)_bN_n]$ represents one or more organic aromatic heterocyclic ligands containing totally n nitrogen atoms, N, which nitrogen atoms are linked to the respective metal. The ligands may be mono- or polycyclic, condensed rings or covalently bonded to each other. In each of the organic heterocyclic aromatic ligands there is at least one acidic group HA and/or its deprotonated form $A^-$, for example COOH, $SO_3H$, $PO_3H_z$, and $COO^-$, $SO3^-$, and $PO_3H^-$ respectively. In total, a which is the number of acid groups HA per dye molecule is from 1 to 12, preferably 1-2.

Preferably, the term "red dye", as used herein, is meant to denote a sensitizer dye expressed by the general formula $(N(C_4H_9)_4)_m[(HOOC)_a(OOC)_bN_4]Ru(NCS)_2$
with a, b, m being integers and
being a value 0 - 4

Preferably, the term "black dye", as used herein, is meant to denote a sensitizer dye expressed by the general formula $(N(C_4H_9)_4)_m[(HOOC)_a(OOC)_bN_3]Ru(NCS)_3$
with a, b, m being integers and
having a value m = 0-4
a and b being a value 0-3

Preferably, the term "Z907-dye", as used herein, is meant to denote a sensitizer dye expressed by the general formula $(N(C_4H_9)_4)_m[(HOOC)_a(OOC)_bN_4]Ru(NCS)_2$
with a, b, m being integers and
being a value 0 - 2

The term "converting into a soluble form" as used herein is meant to refer to a process by which a dye molecule of low, very low or no detectable solubility in a solvent is transformed into a soluble form of said dye molecule in such solvent.

The term "converting into a water-soluble form" as used herein is meant to refer to a process by which a dye molecule of very low or no detectable solubility in water is transformed into a soluble form of said dye molecule in water.

The term "optimum pH" as used herein is meant to refer to a pH value which has been determined for a given dye-solution to influence the physical properties of the dye in a way that allows for the best performance of said dye in a solar cell.

The term "efficiency of DSSCs" as used herein is meant to refer a solar cell's energy conversion efficiency (η) which is the percentage of illuminated light collected and converted to electrical energy when a solar cell is connected to an electrical circuit. This term is calculated using the ratio of $P_{out}$ and $P_{in}$. $P_{out}$ is the energy collected from the solar cell. $P_{in}$ is the product of input light irradiance under "standard" test conditions (L in $W/m^2$) and the surface area of the solar cell ($A_c$ in $m^2$),

$$\eta = P_{out} / P_{in} = FF \times (J_{SC} \times V_{OC}) / (L \times A)$$

FF = fill factor
with FF = $V_{max} \times I_{max} / V_{oc} \times I_{sc}$
$V_{oc}$ = open circuit voltage
$J_{sc}$ = short current density
L = intensity of illumination
A = active area
$V_{max}$ = voltage at maximum power point
$J_{max}$ = current at maximum power point

The term "acid precipitation", as used herein, is meant to refer to a process of adding acid to a mixture whereby a component of this mixture becomes less soluble and/or turns into a solid and thereby precipitates.

The term "adjusting the pH of said dye solution by addition of an appropriated amount of base or acid", as used herein, is meant to refer to the step of adding base or acid in an amount that is necessary to obtain a desired pH. Usually, according to the present invention, the desired pH is in the range of from 4 to 10.

The term "nitrogen atom, N, which is linked to said metal" and/or the term "anion which is linked to said metal", as used herein, is meant to refer to the type of linkage or bond that is typically encountered between a central metal atom of a metal complex and the ligands.

The term "a solvent from which, in the manufacture of a dye-sensitized solar cell (DSSC), adsorption of said dye to a semiconductor layer of said DSSC is carried out", as used herein, is meant to refer to any solvent that is commonly used in the preparation of a dye-sensitized solar cell in the step when the dye sensitizer is adsorbed to the semiconductor layer of the DSSC. Usually, such step is carried out using a solution of the dye sensitizer in such solvent, and from such solution an adsorption to the semiconductor layer of the DSSC is performed simply by immersing the semiconductor layer in such solution. Typical examples of such solvents are lower alcohols, such as methanol, ethanol etc., but also acetonitrile and mixtures of acetonitrile with lower alcohols, preferably C1-C4-alcohols, for example acetonitrile/t-butanol.

Sensitizer dyes are molecules that are capable to absorb light.

Sensitizer dyes based on metal complexes are preferably polypyridyl-based complexes of ruthenium or osmium such as red dye or black dye or their derivative that contain acid groups (HA) for coupling to the surface of semiconductor particles. Normally, such metal complexes are insoluble or show low to very low solubility in a wide range of solvents, so that the up-scaling and automation of the purification process is not possible. The inventors have surprisingly found that the transformation of dye molecules into a soluble form, thereby allowing their efficient purification, followed by acid precipitation and pH adjustment allow the reliable preparation of sensitizer dyes of high purity and quality.

Since the energy levels of the DSSC components (sensitizer and semiconductor) depend on their pH value, a crucial step in tuning the DSSC for best performance is the pH adjustment of the dye-solution. The step is named in this invention "pH-adjustment" or "adjusting the pH of the dye solution". Accordingly, solar cells using "high-quality sensitizer dyes" prepared according to the method of the present invention exhibit a higher efficiency than those using commercially available sensitizer dyes or sensitizer dyes produced according to the conventional methods. The method described in this invention is reliable as well as time and cost efficient. It allows up-scaling and automated purification because it circumvents (e.g. for the red dye) the insolubility of the dye in methanol by purifying the dye in its soluble form 4-TBA red dye, which shows high solubility even in water. The synthesis of red dye is performed using a "one-pot method", and thus involves less synthetic steps (only one). Furthermore, the method does not use expensive chromatography material, such as Sephadex LH-20 and is also environmentally friendly, since organic solvents can be partially replaced by water during the purification process. The inventors have also found that analysis by NMR and analytical HPLC represent excellent tools for the quality control of sensitizer dyes. They are applicable for the analysis of all samples containing the dye as a solid or in solution as well as of material already contained in a solar cell.

In embodiments described herein, a general formula of a dye that may be prepared in accordance with the present invention is $(NR_4)_m[(HA)_a(A)_bN_n]MX_p$,
with a, b, m, n, p being integers and

$$n + p = 6$$

$$m+2 = b + p$$

with all of the indices being integral positive numbers and the following meanings:

$(NR_4)$ represents an ammonium or tetraalkylammonium with R being H or an alkyl group, preferably $C_4$-$C_{12}$-alkyls and m being an integer from 0 to 12, preferably 0-4.
M represents ruthenium or osmium.
X represents $Cl^-$,$Br^-$, $I^-$, $CN^-$, $SCN^-$, $NCS^-$, preferably $NCS^-$ with N being linked to the metal , with p being an integer of from 0 to 4, preferably from 2 to 3.
$[(HA)_a(A)_bN_n]$ represents one or more organic aromatic heterocyclic ligands containing totally n nitrogen atoms, N, which nitrogen atoms are linked to the respective metal. The ligands may be mono- or polycyclic, condensed rings or covalently bonded to each other. In each of the organic heterocyclic aromatic ligands there is at least one acidic group HA and/or its deprotonated form $A^-$, for example COOH, $SO_3H$, $PO_3H_2$, and $COO^-$, $SO3^-$, and $PO_3H^-$ respectively. In total, a which is the number of acid groups HA per dye molecule is from 1 to 12, preferably 1-2. It is clear to someone skilled in the art, that the aforementioned organic aromatic heterocyclic ligands may have additional substituents.

Examples of molecules of the general formula 1 $(NR_4)_m[HA)_a(A)_b$-$N_n]MX_p$

**For 2 TBA red dye:**

R = butyl ($C_4$-alkyl), m = 2
HA = -COOH, a = 2
A = -COO-, b = 2
n= 4
M is ruthenium
X = -NCS, p = 2

**For 4TBA red dye**

R = butyl ($C_4$-alkyl), m = 4
HA = -COOH, a = 0
A = -COO-, b = 4
n= 4
M is ruthenium
X = -NCS, p = 2

**For red dye**

R = butyl ($C_4$-alkyl), m = 0
HA = -COOH, a = 4
A = -COO-, b = 0
n= 4
M is ruthenium
X= -NCS, p = 2

**For black dye:**

R = butyl ($C_4$-alkyl), m = 3
HA = -COOH, a = 1
A = -COO-, b = 2
n= 3
M is ruthenium
X = -NCS, p = 3

**For Z907-dye:**

m = 0 (no tetraalkylammonium)
HA = -COOH, a = 2
b = 0 (no = -COO-)
n= 4
M is ruthenium
X=-NCS,p=2

**For 2TBA-Z907 dye:**

R = butyl ($C_4$-alkyl), m = 2
a = 0 (no -COOH)
A = -COO-, b = 2
n= 4
M is ruthenium
X=-NCS,p=2

The present inventors have surprisingly found that by adding the appropriate amount of $NR_4$-OH to the dye, the dye may be converted into a form which is soluble in different organic solvents, such as methanol, ethanol, acetonitrile, but also in water. The appropriate amount of NR4-OH to be added depends on the total number of acid groups HA per dye molecule a. In the soluble form, the dye can be conveniently purified on a large scale and thereafter isolated by acid precipitation. Thereafter, the dye thus purified may be dissolved in a solvent, such as an alcohol or acetonitrile or a mixture of acetonitrile and alcohol, and the pH of such dye-solution needs to be fine-adjusted to a value in the range of from 4 to 10. The precise value of such optimum pH depends on the actual solvent used. For the sensitizer red dye, such pH value of a dye solution in ethanol is in the range of from 5 to 7, preferably 5.9 to 6.3 and most preferably 6.1 ± 0.5, if said dye solution has a dye concentration in the range from 0.1 mM to 0.5 mM, preferably from 0.2 mM to 0.4 mM and most preferably 0.3 mM, and such pH value of a dye solution in acetonitrile/t-butanol is in the range of from 7 to 9, preferably 7.9 to 8.2 and most preferably 8 ± 0.5, if said dye solution has a dye concentration in the range from 0.1 mM to 0.5 mM, preferably from 0.2 mM to 0.4 mM and most preferably 0.3 mM. One way to determine the exact optimum pH value is to vary the pH of a sensitizer dye-solution and measure the energy conversion efficiency of the corresponding solar cells. The inventors determined it for red dye as best in ethanol as 6.1 and in acetonitrile/t-butanol 1/1 mixture as 8.1 at a dye-solution concentration of 0.3 mM.

A method to characterize the dye is proton NMR. (Figure 7C). The ratio proton signal of H6-bipy and CH3-bipy ("bipy" = bipyridyl) of a commercial sensitizer 2TBA-red dye and "high-quality red dye", i.e. the sensitizer dye produced by the method according to the present invention is summarized in the table below.

| | | pH of 0.3 mM dye-solution | |
|---|---|---|---|
| | 1H NMR- signals ratio **H6**-bipy / **CH3**-TBA | in ethanol | in acetonitrile / t-butanol 1/1 |
| commercial 2TBA red-dye | 1.0 / 10.0 - 1.0 / 18 | 5.3 - 5.8 | 7.1 - 7.8 |
| "high-quality red dye" | 1.0 / 20 - 1.0 / 36 | 5.9 - 6.3 | 7.9 - 8.2 |

The NMR spectrum of "high-quality red dye" shows a H6-bipy and CH3-bipy signal ratio of 1.0 / 20 - 1.0 / 36, preferably 1.0 / 24 - 1.0 / 28. The commercially available sensitizers 2TBA-red dye show signal ratio of H6-bipy and CH3-bipy of 1.0 / 10 - 1.0 / 18.

Further, the pH values of the dye-solutions are lower for the commercially sensitizers. For the "high-quality red dye" the pH value of a 0.3 mM dye solution in ethanol is in the range of from 5.9 to 6.3, and of a 0.3 mM dye solution in acetonitrile/t-butanol (1/1) is in the range of from 7.9 to 8.2, whereas for commercially available sensitizers 2TBA-red dye at same concentration of 0.3 mM is 5.3 to 5.8 in ethanol and 7.1 to 7.8 in acetonitrile/t-butanol (1/1).

Reference is now made to the figures, wherein

**Figure 1A** shows a schematic description of the approach of purifying an embodiment of a sensitizer dye with the general formula $(NR_4)_m[(HA)_a(A)_bN_n]MX_p$ The method comprises following key steps: 1) in-situ transformation of the dye with the given formula to the soluble form of general formula $(NR_4)_{m+a}[(A)_{a+b}N_n]MX_p$ by adding "a" equivalents of $(NR_4)$-OH; 2) Purification by preparative HPLC or MPLC by using reversed-phase material as stationary phase; 3) Dye-isolation as solid by acidic back-titration and dye precipitation; 4) pH-adjustment of the dye solution.

**Figure 1B** shows examples of the ligand containing nitrogen atoms being expressed by general formula $[(HA)_a(A)_bN_n]$. Only core structures of ligands by omitting any other functionalities are depicted.

**Figure 2A** shows the full names and chemical structures behind the abbreviations "red dye", "2TBA-red dye", "4TBA-red dye" and "3-TBA black dye".

**Figure 2B** shows a schematic description of the method to prepare the sensitizer "high-quality red dye". by using as starting material either a) red dye or b) 2TBA-red dye. The method comprises the key steps: 1) in-situ transformation of the a) red dye or b) 2TBA-red dye to the soluble form 4TBA-red dye by adding a) 4 equivalents or b) 2 equivalents of TBA-OH; 2) Purification by preparative HPLC or MPLC by using reversed-phase stationary phase; 3) Dye-isolation as solid after acidic back-titration and dye precipitation; 4) pH-adjustment of the dye solution.

**Figure 2C** schematically shows the preparation of the "high-quality red dye" including the synthesis and purification processes. The method comprises following key steps: 1) one step synthesis of the red dye by the one-pot reaction; 2) in-situ transformation of the red dye to the soluble form 4TBA-red dye by addition of 4 equivalents of TBA-OH; 3) Purification by preparative HPLC by RP-C18 or RP-C8 material as stationary phase; 4) Dye-isolation as solid after acidic back-titration resulting and dye precipitation; 5) pH-adjustment of the dye solution.

**Figure 2D** schematically shows the method to prepare the sensitizer "high-quality black dye" by using the general formula $[N(C_4H_9)_4]_m[(HOOC)_a(OOC)_bN_3]Ru(NCS)_3$. The method includes following key steps: 1) in-situ transformation of the dye to the soluble form of the dye having the general formula $[N(C_4H_9)_4]_4[(OOC)_4N_3]Ru(NCS)_3$ by adding 1 equivalent of TBA-OH; 2) Purification by preparative HPLC or MPLC by using reversed-phase material as stationary phase; 3) Dye-isolation as solid by acidic back-titration and dye precipitation; 4) pH-adjustment of the dye solution.

**Figure 3A** shows HPLC chromatograms of commercially available sensitizer 2TBA-red dye purchased from two different sources, Source A and Source B.

**Figure 3B** shows the table in which the purity determined by HPLC analysis of the respective commercial sensitizers 2TBA-red dye are listed. Further, the energy conversion efficiencies of polymer gel based DSSCs measured with sulphur lamp, 100 $mW/cm^2$ are depicted.

**Figure 4** shows the conventional synthesis method of 2TBA-red dye described by Nazeeruddin et al., (Ref.2). The method includes two synthetic steps to prepare sensitizer red dye and additional 2 steps to prepare its bis-tetrabutylammonium salt 2TBA-red dye.

**Figure 5A** shows, in accordance with one embodiment of the present invention, .the one step synthesis of the red dye by the one-pot reaction reaction.

**Figure 5B** shows the transformation in the soluble form 4TBA-red dye;

**Figure 5C** shows the chromatogram recorded during the purification of the sensitizer dye by HPLC.

**Figure 5D** shows chromatograms of an analytical HPLC of the sensitizer before and after the purification by preparative HPLC.

**Figure 5E** shows the step of acidic-back titration.

**Figure 6A** shows for comparison the analytical HPLC chromatograms of a commercial sensitizer 2TBA red dye and "high-quality red dye" produced according to the method of the present invention.

**Figure 6B** shows for comparison the aromatic region of the NMR spectrum of a commercial sensitizer 2TBA-red dye and "high-quality red dye" produced according to the method of the present invention.

**Figure 7A** shows the NMR spectrum of a commercial sensitizer 2TBA-red dye.

**Figure 7B** shows the NMR spectrum of the "high-quality red dye" after step 4) Dye-isolation of the method described in present invention.

**Figure 7C** shows the NMR spectrum of the "high-quality red dye" after all preparation steps including the one-pot-synthesis and step 5) pH-adjustment.

**Figure 7D** shows a table in which the ratio of proton signals H6-bipy and CH3-TBA in the NMR spectra of commercial 2TBA-red dye (sample 1), "high-quality red dye" after step 4) and isolated "high-quality red dye" (after step5) are listed. Further, the table includes also the pH value of the respective dyes in different solvents.

**Figure 8A** shows the NMR spectrum of a commercial sensitizer 3TBA-black dye.

**Figure 8B** shows the NMR spectrum of the "high-quality black dye"

**Figure 8C** shows a table in which the ratio of proton signals H-terpy and CH3-TBA in the NMR spectra of commercial 3TBA-black dye (sample 1), and "high-quality black dye" (sample 2) prepared by method described in this invention. Further, the table includes also the pH value of the respective dyes in acetonitrile/t-butanol solution.

**Figure 9A** shows the one step synthesis of the Z907-dye by the one-pot reaction reaction.

**Figure 9B** shows the transformation in the soluble form 2TBA-Z907 dye;
**Figure 9C** shows the step of acidic-back titration and pH-adjustment with TBA-OH to isolate "High-quality Z907-dye".
**Figure 10A** shows the NMR spectrum of a commercial Z907-dye.
**Figure 10B** shows the NMR spectrum of the "high-quality Z907-dye"
**Figure 10C** shows for comparison the aromatic region of the NMR spectrum of a commercial sensitizer Z907-dye and "high-quality Z9078-dye" produced according to the method of the present invention.
**Figure 10D** shows a table in which the ratio of proton signals H-bipy and CH3-TBA in the NMR spectra of commercial Z907-dye (sample 1), and "high-quality Z907-dye" (sample 2) prepared by method described in this invention. Further, the table includes also the pH value of the respective dyes in acetonitrile/t-butanol solution.

The invention is now further described by reference to the following examples which are intended to illustrate, not to limit the scope of the invention.

Example 1

General protocol for preparing solar cells containg a) liquid electrolyte and b) polymer gel based electrolyte

The DSSCs are assembled as follows: A 30-nm-thick bulk $TiO_2$ blocking layer is formed on FTO (approx. 100 nm on glass or flexible substrate). A 10-μm-thick porous layer of semiconductor particles is screen printed on the blocking layer and sintered at 450 °C for half an hour. Dye molecules are adsorbed to the nanoporos particles via self-assembling out of a dye-solution (0.3 mM). The porous layer is filled with a) liquid electrolyte b) polymer gel electrolyte containing $I^-/I_3^-$ as redox couple (15 mM) by drop casting. A reflective platinum back electrode is attached with a distance of 6 μm from the porous layer.
The quality of the cells is evaluated by means of current density (J) and voltage (V) characteristics under illumination with light from a sulphur lamp (IKL Celsius, Light Drive 1000) with intensity of 100 mW $cm^{-2}$. If not otherwise stated, the results are averages over three cells, each of 0.24 $cm^2$ active area.

Example 2

Measuring the efficiency of DSSCs based on commercially available sensitizer dyes

The efficiencies of DSSCs assembled according to the protocol of example 1b using commercially available 2TBA-red dye sensitizers were measured. The values given below are averaged values from at least 3 measurements.

Different suppliers

Source A: efficiency = 8.60 %
Source B: efficiency = 6.96 %

Different batches from same supplier

Batch 1: efficiency = 8.03 %
Batch 2: efficiency = 7.21 %
Batch 3: efficiency = 6.71 %

The results showed the unreliable performance of DSSCs due to inconsistency in quality of commercially available 2-TBA red dye sensitizer.

Analytical HPLC of commercially available 2-TBA red dye sensitizers

2-TBA red dye sensitizers from two different commercial sources obtained as solid were soluted in the eluent and directly injected into the HPLC column. RP-C18 was used as column material and methanol /water with 8 mmol TBA-OH/L was used as the eluent. The detector was a photo-diode array (PDA). The chromatograms revealed the varying contamination of the commercially available dyes with impurities and isomers (Figure 3). The purity as determined

by HPLC was 90.2 % for the dye from source A and 95.8 % for the dye from source B correlating to DSSC efficiencies of 5.44 % (source A) and 7.06 % (source B) which were prepared following protocol as described in 1b.

Effects achieved by additional purification of commercially available 2TBA-red dye sensitizer and 2TBA-red dye produced according to the conventional method on the efficiency of DSSCs

The efficiencies of DSSCs assembled according to the protocol of example Ib using commercially available 2TBA-red dye sensitizer, as well as 2TBA-red dye which was produced according to the conventional prior art method (Nazeeruddin *et al.,* see ref. 2; **Figure 4)** were measured.

The method of the purification that has been applied was a conventional method, namely a manual chromatography on Sephadex-LH20 as stationary phase and methanol as eluent. As can be seen in Table 1, the efficiency of the DSSCs increased after each purification step. However, as stated before, the purification by this method is time-consuming and costly.

Table 1

| *Purification: manually by chromatography on Sephadex LH20/methanol* | | efficiency [%] |
|---|---|---|
| **commercial 2TBA-red dye (Source C)** | original | 6.33 |
| | after 1 x purification | 6.96 |
| | after 2 x purification | 7.71 |
| | after 3 x purification | 7.97 |
| **Prepared 2TBA-red dye by applying conventional method** | as synthesized | 7.57 |
| | after 1 x purification | 8.18 |

Example 3

Preparation of "high-quality red dye" sensitizer

The reaction was carried out under inert atmosphere (nitrogen) and exclusion of light. **1** (0.816 mmol) was dissolved in DMF (250 mL) and then 2 (3.26 mmol) was added (**Figure 5A**). The mixture was refluxed at 160 °C for 8 h under constant stirring. High excess (80-fold) of $NH_4NCS$ (65.2 mmol) was added to the reaction mixture and the reflux continued for another 8 h.

The mixture was cooled down to room temperature and the solvent removed by using a rotary evaporator under vacuum. To the resulting viscous liquid 0.2 M aqueous NaOH-solution (10 mL) was added to give a dark purple-red solution. The solution was filtered, and the pH was lowered to pH 1.7 with an acid solution of 0.5 M $HNO_3$ (~ 10 mL) to give a red precipitate. The flask was placed in a refrigerator over night. After the flask was warmed to room temperature, the red solid was collected on a sintered glass crucible by filtration. The solid was washed with water acidified to pH 1.7 with $HNO_3$ (3 x 20 mL) and washed with diethylether/petrolether 1:1 mixture. The crude product was re-dissolved in 0.2 M aqueous NaOH-solution (10 mL) and filtrated over a small pad of Sephadex LH-20 by using water as eluent. The solvent was reduced to a small volume of 10 mL. The product "red dye" was obtained by precipitation after addition of 0.5 M $HNO_3$, washing with diethylether/petrolether 1:1 mixture and drying (1.33 mmol, 82 % yield).

For converting the "red dye" into its soluble form 4TBA-red dye 120 mg (0.162 mmol) of it were diluted in 2 mL water, and 4 calculated equivalents of tetrabutylammonium hydroxide (TBA-OH) (0.647 mmol) were added under stirring **(Figure 5B).**

2mL were directly injected into a HPLC column, and the dye was purified in form of 4TBA-red dye by preparative HPLC. The column consisted of RP-C18 material as stationary phase. As eluent a mixture of methanol or ethanol (solvent A) and water of pH 11 (alkalized by addition of TBA-OH : 8 mmol / 1 L water) (solvent B) was used. A photo-diode array (PDA) was used as detector **(Figure 5C).** Alternatively, measurement of the conductivity or refractive index can be used for detection. The flow was 10 mL/min and a controlled gradient program was employed. The gradient program was following: A/B = 30/70 - 5min - A/B = 30/70 - 40 min- A/B = 70/30 - 15 min - A/B = 70/30. After analyzing the purity of the fractions by analytical HPLC **(Figure 5D),** the dye was transformed from its 4TBA form into the 2TBA-red dye. For that purpose, pure fractions were combined and the volume of the solvent reduced to 5 mL. 0.1 M aqueous trifluoromethansulfonic acid was added very slowly under stirring until a pH value of 4.3 - 4.4 was achieved **(Figure 5E).** The mixture was then placed in a refrigerator for 12 h at 4°C. The precipitated product was isolated by filtration, washed with diethylether/petrolether 1:1 mixture and dried

As indicated by NMR and HPLC analysis, the isolated sensitizer dye is analytically pure, however, in order to achieve the highest DSSC efficiencies a so called "pH-adjustment" step has to be carried out. The pH of the dye-solution is an important factor which has a direct influence of the physical properties of the sensitizer dye and thus, its performance in a solar cell. Therefore, a 0.3 mM solution of dye in ethanol or acetonitrile/t-butanol (1:1) was prepared and the pH values of the solutions were determined. By very slow addition of 0.1 mM TBA-OH methanolic solution or 0.02 mM aqueous trifluoromethan sulfonic acid solution the pH was adjusted under stirring to pH 6.0 - 6.1 (ethanol solution) and pH 8.0 - 8.1 (acetonitrile/t-butanol 1:1 solution). In general, the optimum pH value for a defined solvent concentration has to be determined beforehand: pH 6.1 ± 0.5 for a 0.3 mM ethanol dye-solution; pH 8.05± 0.5 for a 0.3 mM acetonitrile/t-butanol 1:1 dye-solution.

Example 4

Measuring the efficiency of DSSCs containing "high-quality red-dye" sensitizer produced by the method of the present invention

The efficiency of DSSCs assembled according to the protocol of example 1b using the "high-quality red-dye" sensitizer of example 3 were measured and compared to the efficiencies of DSSCs produced with commercially available 2TBA-red dye sensitizers.

The efficiency of a photovoltaic device is calculated as follows:

$$\eta = P_{out} / P_{in} = FF \times (J_{SC} \times V_{OC}) / (L \times A)$$

with FF = $V_{max} \times I_{max} / V_{oc} \times I_{sc}$
FF = fill factor
Voc = open circuit voltage
Jsc = short current density
L = intensity of illumination = 100 $mW/cm^2$
A = active area = 0.24 $cm^2$
$V_{max}$ = voltage at maximum power point
$J_{max}$ = current at maximum power point

As can be seen in Table 2, the efficiency of the DSSCs containing the sensitizer produced according to the method of the present invention is significantly higher. No additional purification steps are necessary.

a) coating of TiO2 from ethanol dye-solution

Table 2

| | $J_{SC}$ [$mA/cm^2$] | $V_{OC}$ [mV] | FF [%] | η[%] |
|---|---|---|---|---|
| Source A: 2TBA-red dye | 18.4 | 610 | 50 | 5.44 |
| Source B: 2TBA-red dye | 20.0 | 670 | 53 | 7.06 |
| "high-quality red dye" | 21.1 | 750 | 55 | 8.71 |

with the IV characterization:

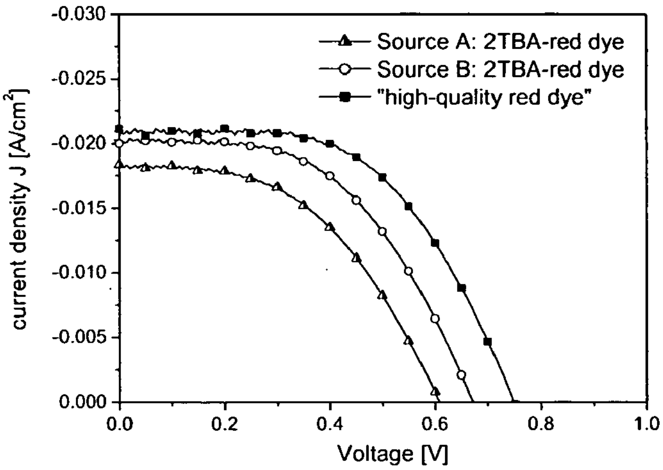


b) coating of $TiO_2$ from acetonitrile/t-butanol 1:1 dye-solution

Table 3

| | $J_{SC}$ [mA/cm$^2$] | $V_{OC}$ [mV] | FF [%] | $\eta$[%] |
|---|---|---|---|---|
| Source A: 2TBA-red dye | 18.2 | 655 | 55 | 6.60 |
| Source B: 2TBA-red dye | 20.3 | 685 | 53 | 7.32 |
| "high-quality red dye" | 19.6 | 750 | 58 | 8.10 |

with the IV characterization:

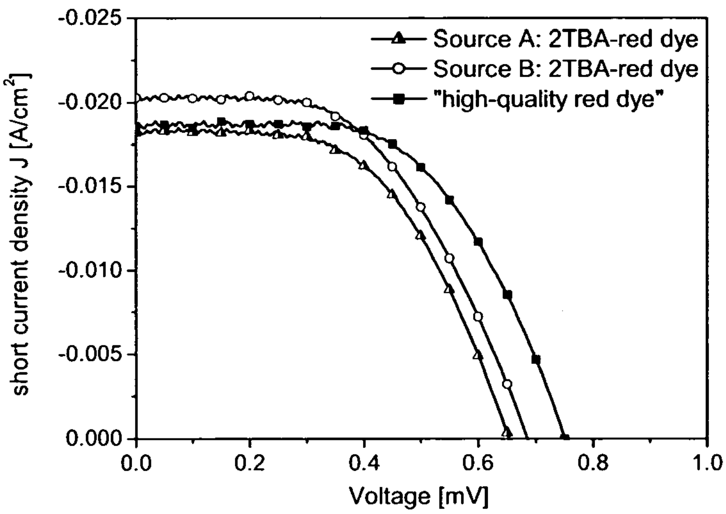


The efficiency of DSSCs assembled according to the protocol of example 1a (liquid electrolyte) using the sensitizer "high-quality red dye" of example 3 were measured and compared to the efficiencies of DSSCs produced with a commercially available sensitizer 2TBA-red dye.

Table 4

| | $J_{SC}$ [mA/cm $^2$] | $V_{OC}$ [mV] | FF [%] | η[%] |
|---|---|---|---|---|
| Source C: 2TBA red dye | 14.9 | 750 | 73 | 8.22 |
| "high-quality red dye" | 20.0 | 785 | 67 | 10.58 |

with IV characterisation

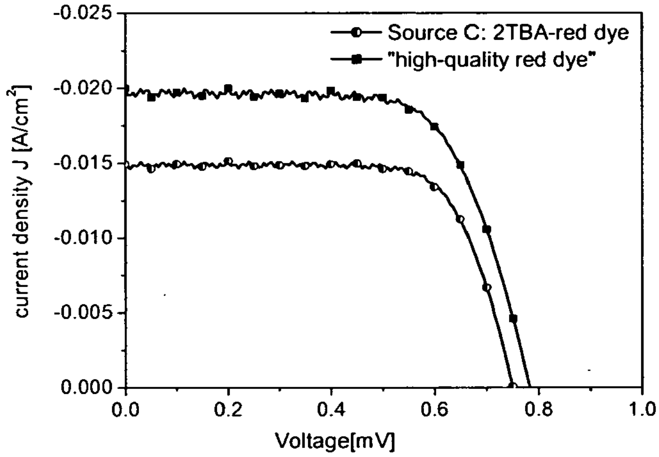


It can be seen that the efficiency of a DSSC using the dye according to the present invention is 28 % higher than a DSSC using a commercially available dye.

Example 5

HPLC and NMR analysis of the sensitizer "high-quality red dye" produced according to the method of the present invention

The purity of the "high-quality red dye" produced according to the method of the present invention was confirmed by analytical HPLC and NMR For comparison the corresponding analytical data of commercially available 2TBA-red dye are depicted. (Figures 6-7).

Figure 6A shows analytical HPLC chromatogram of "high-quality red dye" produced according to the method of the present invention and for comparison that of the commercial available 2TBA-red dye. The peak at ~ 7.2 min corresponds in both chromatograms to the red dye sensitizer. In the chromatogram of the commercial available 2TBA-red dye an additional peak at $R_f$= 6.32 min is observed corresponding to impurity/isomer that commercially available samples generally contain.

**Figure 6B** shows the aromatic range of the NMR spectra containing the signals corresponding to the bipyridine units. The signals at ca. 9.68 and 9.31 ppm are attributed to impurities/isomers that commercial available 2TBA-red dye samples contain, whereas these signals are absent from the sensitizer "high-quality red dye" prepared according to the present invention. This confirms the superior purity of the sensitizer prepared according to the present invention ("high-quality red dye") in comparison to a commercially available dye.

**Figure 7A** shows the NMR spectrum of a commercial available sensitizer 2TBA-red dye. **Figure 7B** shows NMR spectrum of the "high-quality red dye" after step 4) dye-isolation of the method described in present invention and **Figure 7C** shows NMR spectrum of the "high-quality red dye" after all preparation steps including the one-pot-synthesis and step 5) pH-adjustment. In **Figure 7D** a table is depicted in which the ratio of proton signals H6-bipy and CH3-TBA in the NMR spectra of commercially available sensitizer 2TBA-red dye "high-quality red dye" after step 4) and isolated "high-quality red dye" (after step 5) are listed. Further, the table includes also the pH value of the respective sensitizers in different solvents. The NMR spectrum of the "high-quality red dye" and the pH values of the corresponding dye-solution are characteristic and considered as a fingerprint of the sensitizer quality produced by the method described in this invention. The ratio of proton signals H6-bipy and CH3-TBA in the NMR spectrum of the "high-quality red dye" sensitizer

is 1.0/27.5, whereas that of commercially available sensitizer 2TBA-red dye is 1.0/10.3. The pH value of a 0.3 mM ethanol dye-solution is for "high-quality red dye" sensitizer 6.1, whereas that of commercially available sensitizer 2TBA-red dye is 5.3. The pH value of a 0.3 mM acetonitrile/t-butanol (1/1) dye-solution is for "high-quality red dye" sensitizer 8.1, whereas that of commercially available sensitizer 2TBA-red dye is 7.1.

Example 6

Preparation of "high-quality black dye" sensitizer

"3TBA-black dye", the starting material for the preparation, can be either a commercial available sample (Companies as for red dye: Solaronix, Dyesol) or can be prepared by method described in the literature: M.K. Nazeeruddin et al., J. Am. Chem. Soc. 2001, 123, 1613-1624.

For converting the "3TBA-black dye" into its soluble form 4TBA-black dye 100 mg (0.162 mmol) of it were diluted in 2 mL water, and 1 calculated equivalent of tetrabutylammonium hydroxide (TBA-OH) (0.162 mmol) were under stirring added.

2mL were directly injected into the injector of a preparative HPLC instrument, and the dye was purified in form of 4TBA-black dye. The HPLC column consisted of RP-C18 material as stationary phase. As eluent a mixture of methanol or ethanol (solvent A) and water of pH 11 (alkalized by addition of TBA-OH: 8 mmol / 1 L water) (solvent B) was used. A photo-diode array (PDA) was used as detector. Alternatively, measurement of the conductivity or refractive index can be used for detection. The flow was 10 mL/min and a controlled gradient program was employed. The gradient program was following: A/B = 30/70 - 5min - A/B = 30/70 - 40 min- A/B = 70/30 - 15 min - A/B = 70/30. The fractions containing the pure dye were collected, the solvent evaporated and the volume of the solvent reduced to ca. 3 mL. The dye was transformed from its 4TBA form into the 3TBA-black dye by slow addition of 0.1 M aqueous nitric acid. The precipitated product was isolated by filtration, washed with diethylether/petrolether 1:1 mixture and dried (91 mg; 0.146 mmol).

As indicated by NMR and HPLC analysis, the isolated sensitizer dye is analytically pure, however, in order to achieve the highest DSSC efficiencies a so called "pH-adjustment" step has to be carried out. The pH of the dye-solution is an important factor which has a direct influence of the physical properties of the sensitizer dye and thus, its performance in a solar cell. Therefore, a 0.3 mM solution of dye in acetonitrile/t-butanol (1:1) was prepared and the pH values of the solutions were determined. By very slow addition of 0.1 mM TBA-OH methanolic solution the pH was adjusted under stirring to pH 9.3 - 10.2 (acetonitrile/t-butanol 1:1 solution). In general, the optimum pH value for a defined solvent concentration has to be determined beforehand: pH 9.6 $\pm$ 0.2 for a 0.3 mM acetonitrile/t-butanol (1:1) high-quality black dye-solution. After pH-adjustment, either the solvent can be removed and the product isolated as solid, or the so prepared dye-solution can be directly used for coating the nanoporous semiconductor layer.

Example 7

Measuring the efficiency of DSSCs containing "high-quality black-dye" sensitizer produced by the method of the present invention

The efficiency of DSSCs assembled according to the protocol of example 1b using the "high-quality black-dye" sensitizer of example 6 were measured and compared to the efficiencies of DSSCs produced with commercial 3TBA-black dye sensitizer (commercial name also: Ru620-1 H3TBA or Ru620 or N749).

The efficiency of a photovoltaic device is calculated as follows:

$$\eta = P_{out} / P_{in} = FF \times (J_{SC} \times V_{OC}) / (L \times A)$$

with FF = $V_{max} \times I_{max} / V_{OC} \times I_{SC}$
FF = fill factor
$V_{OC}$ = open circuit voltage
$J_{SC}$ = short current density
L = intensity of illumination = 100 mW/cm$^2$
A = active area = 0.24 cm$^2$
$V_{max}$ = voltage at maximum power point
$J_{max}$ = current at maximum power point
IPCE-curves are "Incident-photon-current efficiency" indicating the photo-activity of a sensitizer dye by representing the ability of the dye to inject respective electrons into the semiconductor conduction band.

As can be seen in Table 5, the efficiency of the DSSCs containing the sensitizer produced according to the method of the present invention is significantly higher. Coating of $TiO_2$ with dye was done from a 0.3 mM acetonitrile/t-butanol (1:1).

Table 5

| | $J_{SC}$ [mA/cm$^2$] | $V_{OC}$ [mV] | FF [%] | η[%] |
|---|---|---|---|---|
| commercial 3TBA-black dye | 15.4 | 700 | 72 | 7.76 |
| "high-quality black dye" | 15.9 | 720 | 71 | 8.19 |

with the IV characterization:

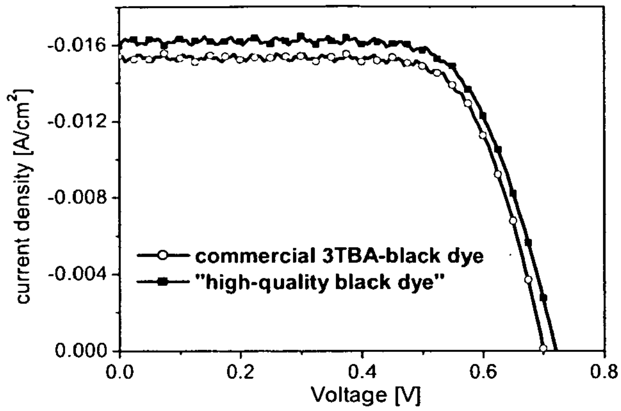


and photoaction curve

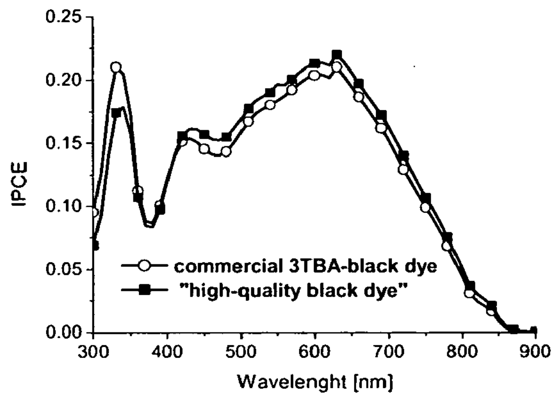


Example 8

NMR analysis of the sensitizer "high-quality black dye" produced according to the method of the present invention

The purity of the "high-quality black dye" produced according to the method of the present invention was confirmed by NMR. For comparison the corresponding NMR spectrum of commercial 3TBA-black dye are depicted. (**Figures 8**).

**Figure 8A** shows the NMR spectrum of a commercial available sensitizer 3TBA-black dye. **Figure 8B** shows NMR spectrum of the "high-quality black dye". In **Figure 8C** a table is depicted in which the ratio of proton signals H-terpy and CH3-TBA in the NMR spectrum of commercial sensitizer 3TBA-black dye and "high-quality black dye" are listed. The table includes also the pH value of the respective sensitizer.

The NMR spectrum of the "high-quality black dye" and the pH values of the corresponding dye-solution are characteristic and considered as a fingerprint of the sensitizer quality produced by the method described in this invention. The ratio of proton signals H-terpy and CH3-TBA in the NMR spectrum of the "high-quality black dye" sensitizer is 1.0/23.8, whereas that of commercially available sensitizer 3TBA-black dye is 1.0/15.7. The pH value of a 0.3 mM acetonitrile/t-butanol (1/1) dye-solution is for "high-quality black dye" sensitizer 9.6, whereas that of commercially available sensitizer 3TBA-black dye is 9.1.

Example 9

Preparation of ""high-quality Z907-dye" sensitizer

$[RuCl_2(p\text{-cymene})]_2$ was dissolved in DMF and 4,4'dinonyl 2,2' bipyridine then added. The reaction mixture was heated to 70-80 °C under nitrogen for 4 h with constant stirring. To this reaction flask 4,4'-carboxy-2,2' -bipyridine was added and the mixture refluxed at 170-180 °C for 4 h. Finally, excess of $NH_4NCS$ was added to the reaction mixture and the reflux at 180°C continued for another 12 h.
The reaction mixture was cooled down to room temperature and the solution was filtered (use the system without gummi-ring). The solvent was removed by using a rotary evaporator under vacuum. Water was added to the flask in order to remove excess of $NH_4SCN$. The insoluble solid was collected on a sintered glass crucible by filtration. The solid was washed with water and diethyl ether.
The solid was washed re-dissolved by adding 0.2 mM aq. NaOH and re-precipitated by slowly adding 0.1 mM aq. $HNO_3$. The solid is isolated by filtration or centrifugation.
The reaction was carried out under inert atmosphere (nitrogen) and exclusion of light. **1** (0.4 mmol) was dissolved in DMF (250 mL) and then 2 (0.8 mmol) was added (**Figure 9A**). The mixture was stirred at 70-80 °C for 8 h. After adding 3 (0.8 mmol) the mixture was refluxed at 170-180 °C for 4 h. High excess (20-fold) of $NH_4NCS$ (16 mmol) was added to the reaction mixture and the reflux continued for another 8 h.
The mixture was cooled down to room temperature and the solvent removed by using a rotary evaporator under vacuum. To the resulting viscous liquid 0.2 M aqueous NaOH-solution (10 mL) was added to give a dark purple-red solution. The solution was filtered, and the pH was lowered by addition of of 0.5 M $HNO_3$ (~ 5 mL) to give a red precipitate. The flask was placed in a refrigerator over night. After the flask was warmed to room temperature, the red solid was collected on a sintered glass crucible by filtration. The solid was washed with acidified and than with diethylether/petrolether 1:1 mixture. The crude product was re-dissolved in 0.2 M aqueous NaOH-solution (10 mL) and filtrated over a small pad of Sephadex LH-20 by using water as eluent. The solvent was reduced to a small volume of 10 mL. The product "Z907-dye" was obtained by precipitation after addition of 0.5 M $HNO_3$, washing with diethylether/petrolether 1:1 mixture and drying (0.62 mmol, 77 % yield).
For converting the "Z907 dye" into its soluble form 2TBA-Z907 dye 100 mg (0.114 mmol) of it were diluted in 2 mL water, and 2 calculated equivalents of tetrabutylammonium hydroxide (TBA-OH) (0.228 mmol) were added under stirring **(Figure 9B).**
2mL were directly injected into the injector of the HPLC instrument, and the dye was purified in form of 2TBA-Z907 dye by preparative HPLC. The column consisted of RP-C18 material as stationary phase. As eluent a mixture of methanol or ethanol (solvent A) and water of pH 11 (alkalized by addition of TBA-OH : 8 mmol / 1 L water) (solvent B) was used. A photo-diode array (PDA) was used as detector. Alternatively, measurement of the conductivity or refractive index can be used for detection. The flow was 10 mL/min and a controlled gradient program was employed. The gradient program was following: A/B = 60/40 - 5min - A/B = 60/40 - 40 min- A/B = 90/10 - 15 min - A/B = 90/10. The fractions containing the pure dye were collected, the solvent evaporated and the volume of the solvent reduced to ca. 3 mL. The dye was transformed from its 2TBA- form into the Z907 dye by slow addition of 0.1 M aqueous nitric acid ((Figure 9C). The precipitated product was isolated by filtration, washed with diethylether/petrolether 1:1 mixture and dried (89 mg; 0.101 mmol). As indicated by NMR and HPLC analysis, the isolated sensitizer dye is analytically pure, however, in order to achieve the highest DSSC efficiencies a so called "pH-adjustment" step has to be carried out. The pH of the dye-solution is an important factor which has a direct influence of the physical properties of the sensitizer dye and thus, its performance in a solar cell. Therefore, a 0.3 mM solution of dye in acetonitrile/t-butanol (1:1) was prepared and the pH values of the solutions were determined. By very slow addition of 0.1 mM TBA-OH methanolic solution the pH was adjusted under stirring to pH 6 - 7 (acetonitrile/t-butanol 1:1 solution). In general, the optimum pH value for a defined solvent concentration has to be determined beforehand: pH 7.6 $\pm$ 0.2 for a 0.3 mM acetonitrile/t-butanol (1:1) high-quality Z907 dye-solution. After pH-adjustment, either the solvent can be removed and the product isolated as solid, or the so prepared dye-solution can be directly used for coating the nanoporous semiconductor layer.

Example 10

NMR analysis of the sensitizer "high-quality Z907 dye" produced according to the method of the present invention

The purity of the "high-quality Z907 dye" produced according to the method of the present invention was confirmed by NMR. For comparison the corresponding NMR spectrum of commercial Z907 dye are depicted. (**Figures 10**).

**Figure 10A** shows the NMR spectrum of a commercial available sensitizer Z907 dye. **Figure 10B** shows NMR spectrum of the "high-quality Z907 dye".

**Figure 10C** shows the aromatic range of the NMR spectra containing the signals corresponding to the bipyridine units. The small signals at ca. 9.35, 9.83 or 7.0 ppm are attributed to impurities/isomers that commercial Z907 dyes contain, whereas these signals are absent from the sensitizer "high-quality Z907 dye" prepared according to the present invention. This confirms the superior purity of the sensitizer prepared according to the present invention ("high-quality Z07 dye") in comparison to a commercially available dye.

In **Figure 10D** a table is depicted in which the ratio of proton signals H-bipy and CH3-TBA in the NMR spectra of commercial sensitizer Z907 dye and isolated "high-quality Z907 dye" are listed. Further, the table includes also the pH value of the respective sensitizers in different solvents.

The NMR spectrum of the "high-quality Z907 dye" and the pH values of the corresponding dye-solution are characteristic and considered as a fingerprint of the sensitizer quality produced by the method described in this invention. The ratio of proton signals H-bipy and CH3-TBA in the NMR spectrum of the "high-quality Z907 dye" sensitizer is 1.0/17.5, whereas the commercial Z907 dye doesn't contain any TBA. The pH value of a 0.3 mM acetonitrile/t-butanol (1/1) dye-solution is for sensitizer "high-quality Z907 dye" 7.6, whereas that of commercial Z907 dye is 6.6.

Measuring the efficiency of DSSCs containing "high-quality Z907-dye" sensitizer produced by the method of the present invention

The efficiency of DSSCs assembled according to the protocol of example 1b using the "high-quality Z907-dye" sensitizer of example 9 were measured and compared to the efficiencies of DSSCs produced with commercial Z907 dye sensitizer (commercial name also: Ru520-DN).

The efficiency of a photovoltaic device is calculated as follows:

$$\eta = P_{out} / P_{in} = FF \text{ x } (J_{SC} \text{ x } V_{OC}) / (L \text{ x } A)$$

with FF = $V_{max}$ x $I_{max}$ $V_{OC}$ X $I_{SC}$
FF = fill factor
$V_{OC}$ = open circuit voltage
$J_{SC}$ = short current density
L = intensity of illumination = 100 mW/cm$^2$
A = active area = 0.24 cm$^2$
$V_{max}$ = voltage at maximum power point
$J_{max}$ = current at maximum power point

IPCE-curves are "Incident-photon-current efficiency" indicating the photo-activity of a sensitizer dye by representing the ability of the dye to inject respective electrons into the semiconductor conduction band.

As can be seen in Table 6, the efficiency of the DSSCs containing the sensitizer produced according to the method of the present invention is significantly higher.

Coating of $TiO_2$ with dye was done from a 0.3 mM acetonitrile/t-butanol (1:1).

Table 6

| | $J_{SC}$ [mA/cm$^2$] | $V_{OC}$ [mV] | FF [%] | $\eta$[%] |
|---|---|---|---|---|
| commercial Z907 dye | 20.0 | 740 | 67 | 9.92 |
| "high-quality Z907-dye" | 21.9 | 740 | 65 | 10.47 |

with the IV characterization:

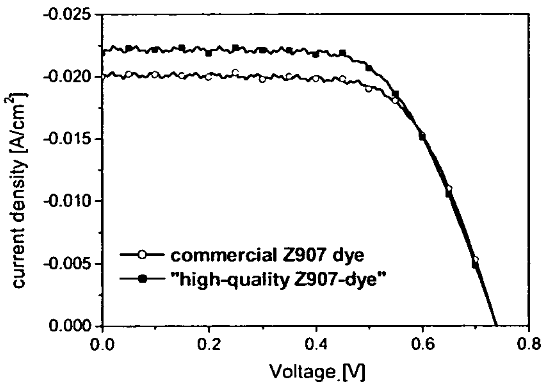


and photoaction curve

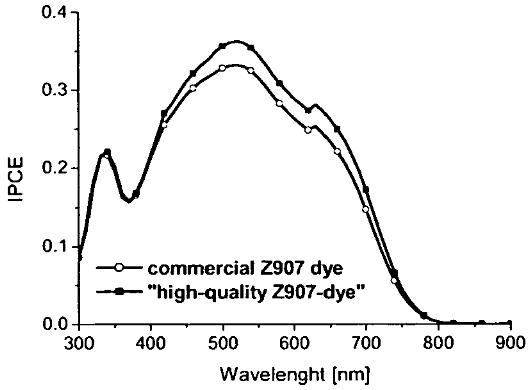


The features of the present invention disclosed in the specification, the claims and/or in the accompanying drawings, may, both separately, and in any combination thereof, be material for realizing the invention in various forms thereof.

## Claims

1. A method of purifying a dye for use in dye-sensitized solar cells (DSSC), comprising the steps:

    (i) providing a dye which is useful as sensitizer in a dye-sensitized solar cell,
    (ii) converting said dye into a soluble form, preferably a water-soluble form, of said dye by adding $NR_4$-OH, wherein R is H or alkyl, preferably $C_4$-$C)_2$-alkyl, more preferably butyl,
    (iii) purifying said soluble form of said dye by reversed-phase chromatography, preferably using HPLC,
    (iv) isolating said dye by acid precipitation,
    (v) dissolving said dye resulting from step (iv) in a solvent to provide a dye-solution and adjusting the pH of said dye solution to a value in the range of from 4 to 10.

2. The method according to claim 1, wherein said dye has a number "a" of acidic groups HA per molecule that may release a proton or, in their deprotonated form $A^-$, may accept a proton, and in step (ii) an amount of $NR_4$-OH equimolar to "a" is added so as to convert said dye into a soluble, preferably water-soluble, form.

3. The method according to any of claims 1 - 2, wherein said solvent is a solvent from which, in the manufacture of a dye-sensitized solar cell (DSSC), adsorption of said dye to a semiconductor layer of said DSSC is carried out.

4. The method according to any of claims 1 - 3, wherein said solvent is selected from acetonitrile, a lower alcohol having 1-6 C-atoms, such as methanol, ethanol, propanol, isopropanol, butanol, *t*-butanol, or methoxypropionitrile, dimethylformamide, or any mixture containing these solvents.

5. The method according to claim 4, wherein said solvent is a lower alcohol having 1-6 C-atoms, preferably ethanol, and said pH of said dye-solution is adjusted to a range of from 5 to 7, preferably 5.9 to 6.3 and most preferred 6.1 $\pm$ 0.5, if said dye solution has a dye concentration in the range from 0.1 mM to 0.5 mM, preferably from 0.2 mM to 0.4 mM, or wherein said solvent is a 1/1 mixture of acetonitrile/t-butanol and said pH of said dye-solution is adjusted to a range of from 7 to 9, preferably, 7.9 to 8.2 and most preferred 8 $\pm$ 0.5, if said dye solution has a dye concentration in the range from 0.1 mM to 0.5 mM, preferably from 0.2 mM to 0.4 mM.

6. The method according to any of claims 1-5, wherein, in step (v), adjusting the pH of said dye solution occurs by addition of an appropriate amount of base or acid.

7. The method according to claim 6, wherein said base is $NR_4$-OH, R being as defined in claim 1, and wherein said acid is trifluoromethanesulfonic acid, trifluoroacetic acid, nitric acid, acetic acid or sulphuric acid.

8. The method according to any of claims 1-7, wherein said dye is a metal-complex having one or more aromatic heterocyclic ligands, said ligand containing at least one nitrogen atom, N, which is linked to said metal.

9. The method according to claim 8, wherein said metal is ruthenium or osmium, preferably ruthenium.

10. The method according to any of claims 8-9, wherein said dye is a compound having the formula

$$(NR_4)_m [(HA)_a(A)_b\text{-}N_n]MX_p,$$

with a, b, m, n, p being integers and being selected from 0 - 20, with the proviso that

$$n + p = 6,$$

$$m + 2 = b + p,$$

m being selected from 0-12, preferably 0-4,
$NR_4$ being a tetraalkylammonium or ammonium,
R being H or alkyl, preferably $C_4$ - $C_{12}$, alkyl,
M being a metal selected from ruthenium or osmium, preferably ruthenium,
X being an anion with
p being selected from 0-4, preferably 2 or 3,
HA being an acidic group and
A being a basic group corresponding to said acidic group HA after release of a proton from HA,

with a denoting the total number of acidic groups HA per dye molecule and being in the range of from 1-12, preferably 1-4, and more preferably 1-2,
$[(HA)_a(A)_b\text{-}N_n]$ being said one or more aromatic heterocyclic ligands containing n nitrogen atoms linked to M, n denoting the total number of nitrogen atoms per dye molecule.

11. The method according to any of claims 9-10 wherein said dye is a pyridyl complex of ruthenium, preferably a polypyridyl complex of ruthenium.

12. The method according to any of claims 10-11, wherein said acidic group HA is selected from -COOH, $-SO_3H$ and $-PO_3H_2$.

13. The method according to any of claims 8-12, wherein said aromatic heterocyclic ligand is a mono- or polycyclic condensed ring system or a system of rings covalently bonded to each other, wherein, optionally, said ring system

or rings are substituted with further substituents, such as halogens or functional groups such as OH, $NH_2$, and/or have further groups R' attached, R' being H, alkyl, aryl, alkoxy, $NR''_2$, R" being H or alkyl.

**14.** The method according to any of claims 9-13, wherein said aromatic heterocyclic ligand has a core to which said HA and/or A groups and, optionally, further substituents, as defined in claim 13, are attached, which core is selected from the group comprising

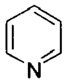
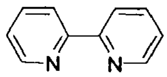
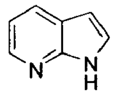
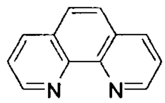

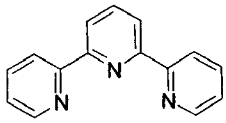
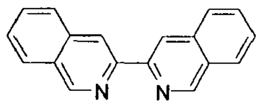
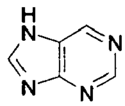

**15.** The method according to any of claims 10-14, wherein said anion X, at each occurrence, is independently selected from the group comprising $Cl^-$, $Br^-$, $I^-$, $[CN]^-$, $[NCS]^-$preferably being $[NCS]^-$ with N linked to the metal M.

**16.** The method according to any of claims 1-15, wherein said dye is cis-bis(isothiocyanato) bis(2,2'-bipyridyl-4,4'-dicarboxylato)-ruthenium(II) ("red dye").

**17.** The method according to claim 16, wherein in step (ii), 4 equivalents of $NR_4$-OH to the amount of "red dye" is added, R being H or alkyl, preferably $C_4$-$C_{12}$ alkyl.

**18.** The method according to any of claims 1-15, wherein said dye is cis-bis (isothiocy-anato)bis(2,2'bipyridyl-4,4'-dicarboxylato)-ruthenium(II) bis-tetrabutylammonium ("2TBA-red dye").

**19.** The method according to claim 18, wherein, in step (ii), 2 equivalents of $NR_4$-OH to the amount of "2TBA-red dye" is added, R being H or alkyl, preferably $C_4$-$C_{12}$ alkyl.

**20.** The method according to any of claims 1-15, wherein said dye is tris(isothiocyanato)-ruthenium(II)-(2,2' : 6',2"-terpyridine -4,4',4"-tri-carboxylato) tris-tetrabutylammonium salt ("3TBA-black dye").

**21.** The method according to claim 20, wherein, in step (ii), 1 equivalent of $NR_4$-OH to the amount of "3TBA-black dye" is added, R being H or alkyl, preferably $C_4$-$C_{12}$ alkyl.

**22.** A one-pot method of synthesizing cis-bis(isothiocyanato)bis(2,2'-bipyridyl-4,4'-dicarboxylato)-ruthenium(II) ("red dye") comprising the steps:

a) providing, in any order,
dimeric (p-cymol)-ruthenium(II)chloride and 2,2'-bipyridine-4,4'-dicarboxylic acid,
b) allowing said dimeric (p-cymol)-ruthenium(II)chloride and 2,2'-bipyridine-4,4'-dicarboxylic acid to react in a single reaction mixture,
c) adding a thiocyanate salt to said reaction mixture and allowing said reaction mixture to react to yield red dye.

**23.** The method according to claim 22 wherein steps b) and c) are performed at a temperature > 100°C and preferably under inert atmosphere and exclusion of light.

**24.** The method according to claim 22-23, wherein steps b) and c) are performed at a temperature > 140°C, preferably in the range of from 150°C to 180°C and under inert atmosphere and exclusion of light.

**25.** A dye purified by the method according to any of claims 1-21 or prepared by the method according to any of claims

22-24, and having no impurities, preferably no impurities detectable in an NMR-spectrum.

**26.** A dye purified by the method according to any of claims 1-21 and being **characterized by** analytical HPLC showing HPLC-purity higher than 99%.

**27.** A dye purified by the method according to any of claims 1-21 and being **characterized by** a HPLC trace shown hereafter, using the following conditions:

column material: reversed phase, preferably C18 or C8
eluent: mixture of alcohol, such as ethanol or methanol/water or acetonitrile/water at pH 7-11, preferably 9-11

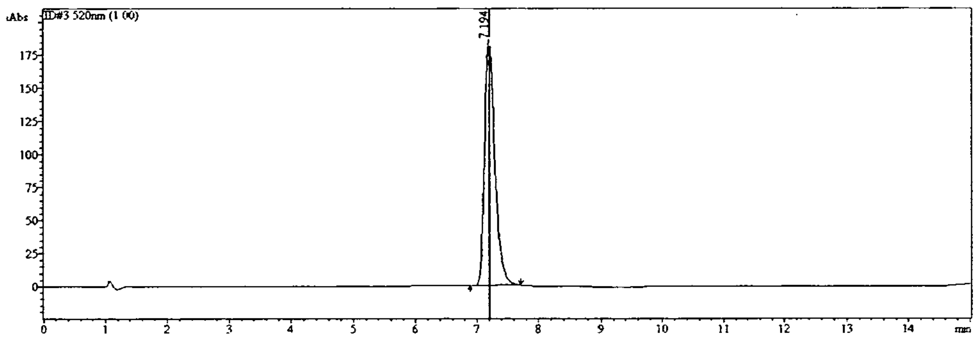


and preferably also by a UV-Vis spectrum represented by:

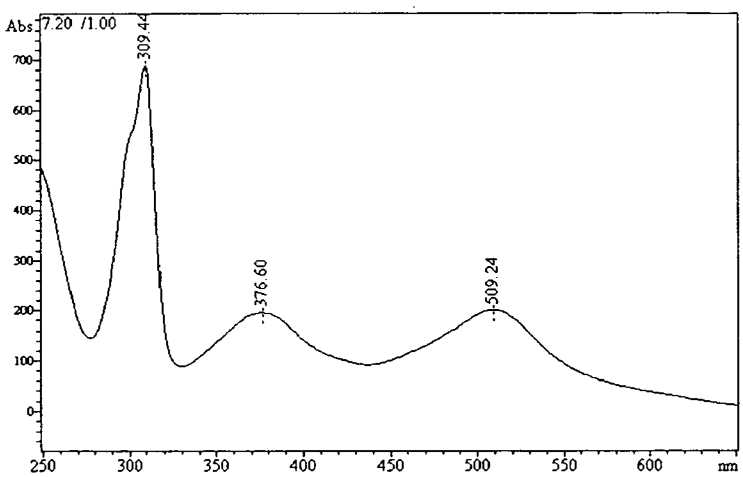


**28.** A solution of a dye purified by the method according to any of claims 1-21 and having a pH in the range of from 4 to 11, preferably 4 to 10.

**29.** The solution according to claim 28, wherein the solvent is ethanol and the pH of said solution at a concentration of 0.3 mM dye is in the range of from 5 to 7, preferably 6.1 $\pm$ 0.5.

**30.** The solution according to claim 28, wherein the solvent is acetonitrile/t-butanol and the pH of said solution at a concentration of 0.3 mM dye is in the range of from 7 to 9, preferably 8.05 $\pm$ 0.5.

**31.** A dye obtained by evaporating the solvent from the solution according to any of claims 28-30.

**32.** The dye according to claim 31, wherein said evaporation occurs by freeze-drying or rotary evaporation.

**33.** The dye obtained as solid after evaporation according to claim 31-32.

**34.** A dye-sensitized solar cell produced using the dye according to claim 33.

**35.** A dye-sensitized solar cell produced using directly the solution according to any of claims 28-30.

A

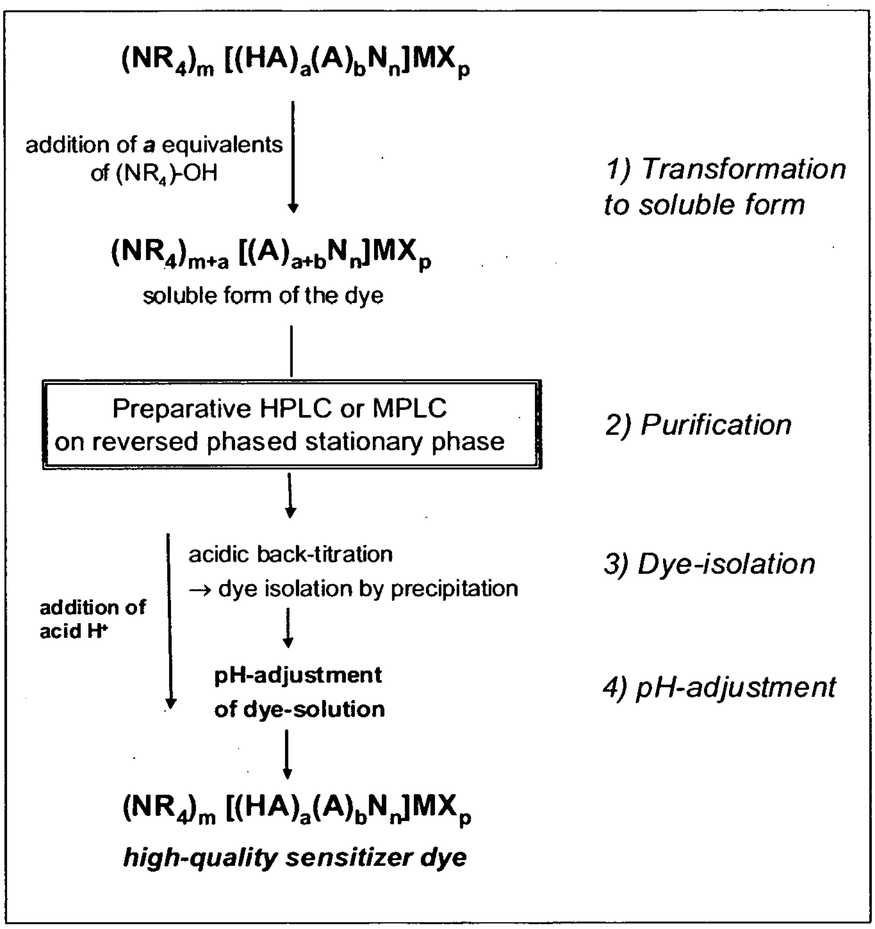

$(NR_4)_m$ $[(HA)_a(A)_bN_n]MX_p$
addition of *a* equivalents of $(NR_4)$-OH
1) Transformation to soluble form
$(NR_4)_{m+a}$ $[(A)_{a+b}N_n]MX_p$
soluble form of the dye
Preparative HPLC or MPLC on reversed phased stationary phase
2) Purification
acidic back-titration
→ dye isolation by precipitation
3) Dye-isolation
addition of acid $H^+$
pH-adjustment of dye-solution
4) pH-adjustment
$(NR_4)_m$ $[(HA)_a(A)_bN_n]MX_p$
high-quality sensitizer dye


B

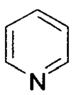
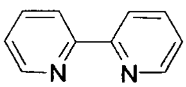
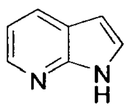
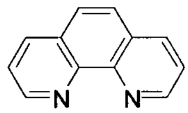
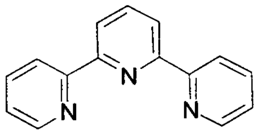
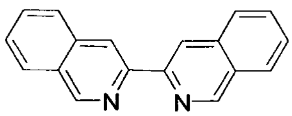
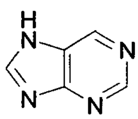

FIGURE 1

A

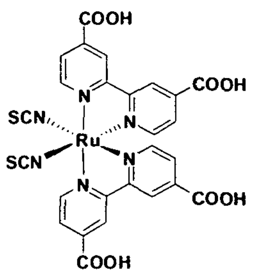

cis-bis(isothiocyanato)bis(2,2'-bipyridyl-4,4'-dicarboxylato)-ruthenium(II)

Abrev. **red dye**

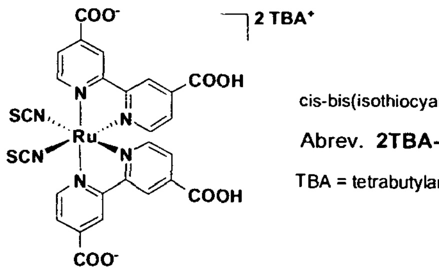

cis-bis(isothiocyanato)bis(2,2'-bipyridyl-4,4'-dicarboxylato)-ruthenium(II) bis-tetrabutylammonium

Abrev. **2TBA-red dye**

TBA = tetrabutylammonium

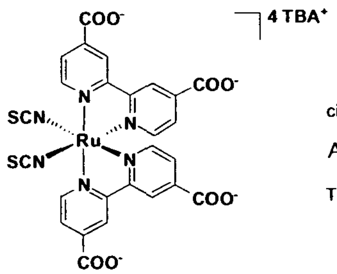

cis-bis(isothiocyanato)bis(2,2'-bipyridyl-4,4'-dicarboxylato)-ruthenium(II) tetrakis-tetrabutylammonium

Abrev. **4TBA-red dye**

TBA = tetrabutylammonium

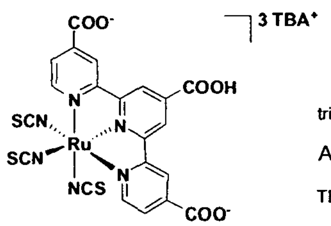

tris(isothiocyanato)-(2,2':6'2"-terpyridyl-4,4',4"-tricarboxylato)-ruthenium(II) tris-tetrabutylammonium salt

Abrev. **3TBA-black dye**

TBA = tetrabutylammonium

FIGURE 2

B

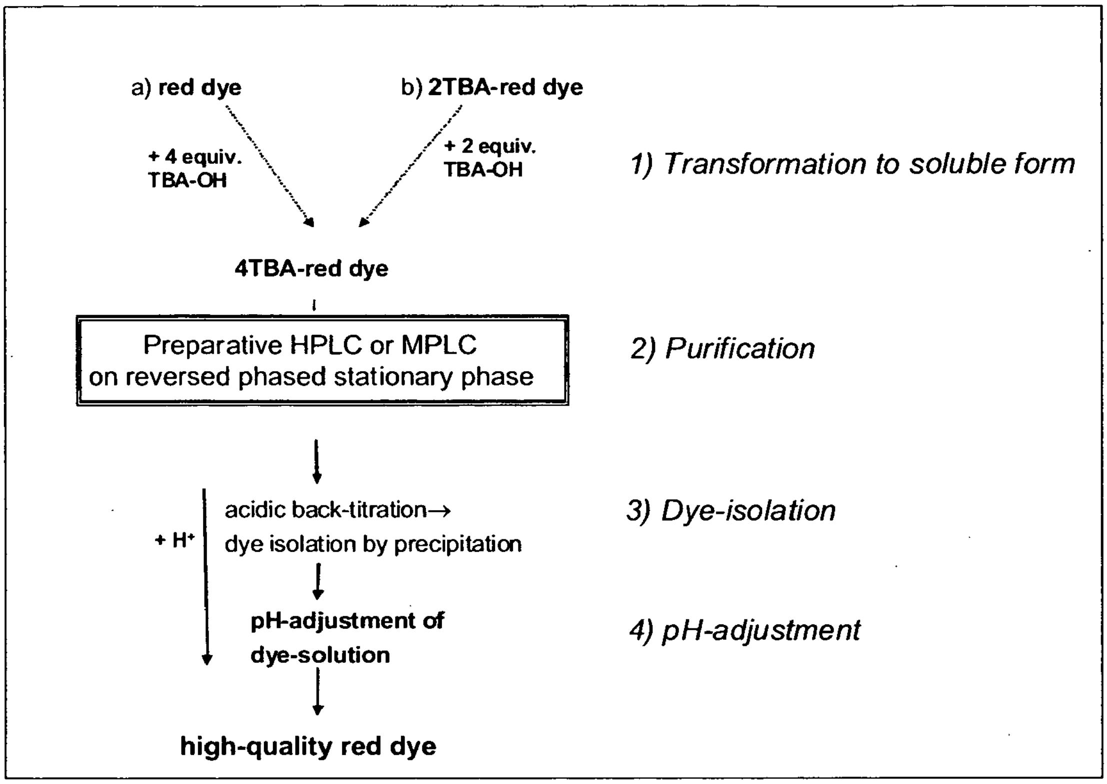
a) red dye
b) 2TBA-red dye
+ 4 equiv. TBA-OH
+ 2 equiv. TBA-OH
1) Transformation to soluble form
4TBA-red dye
Preparative HPLC or MPLC on reversed phased stationary phase
2) Purification
+ H+
acidic back-titration→ dye isolation by precipitation
3) Dye-isolation
pH-adjustment of dye-solution
4) pH-adjustment
high-quality red dye

FIGURE 2

C

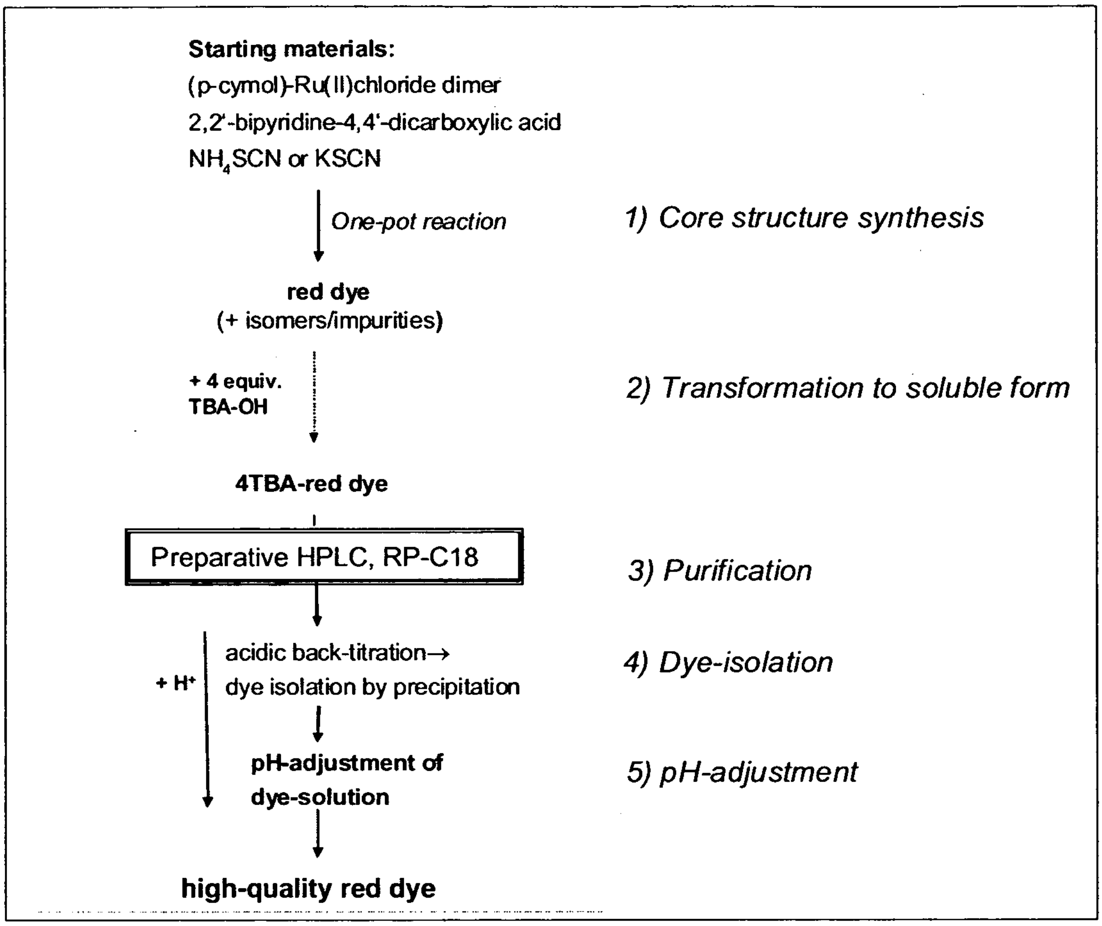
Starting materials:
(p-cymol)-Ru(II)chloride dimer
2,2'-bipyridine-4,4'-dicarboxylic acid
$NH_4SCN$ or KSCN
One-pot reaction
1) Core structure synthesis
red dye
(+ isomers/impurities)
+ 4 equiv. TBA-OH
2) Transformation to soluble form
4TBA-red dye
Preparative HPLC, RP-C18
3) Purification
+ $H^+$
acidic back-titration→
dye isolation by precipitation
4) Dye-isolation
pH-adjustment of dye-solution
5) pH-adjustment
high-quality red dye

FIGURE 2

D

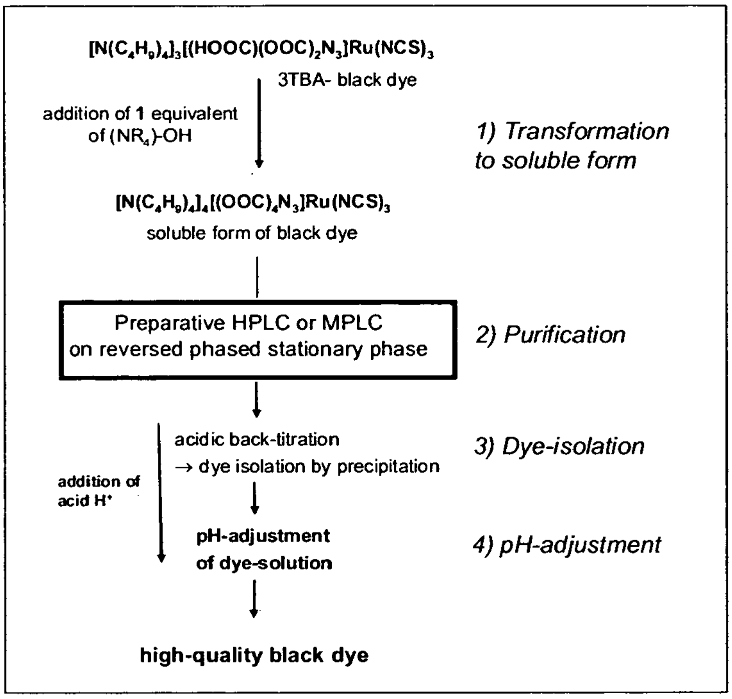
$[N(C_4H_9)_4]_3[(HOOC)(OOC)_2N_3]Ru(NCS)_3$
3TBA- black dye
addition of 1 equivalent of $(NR_4)$-OH
1) Transformation to soluble form
$[N(C_4H_9)_4]_4[(OOC)_4N_3]Ru(NCS)_3$
soluble form of black dye
Preparative HPLC or MPLC on reversed phased stationary phase
2) Purification
acidic back-titration
→ dye isolation by precipitation
3) Dye-isolation
addition of acid $H^+$
pH-adjustment of dye-solution
4) pH-adjustment
high-quality black dye

FIGURE 2

A

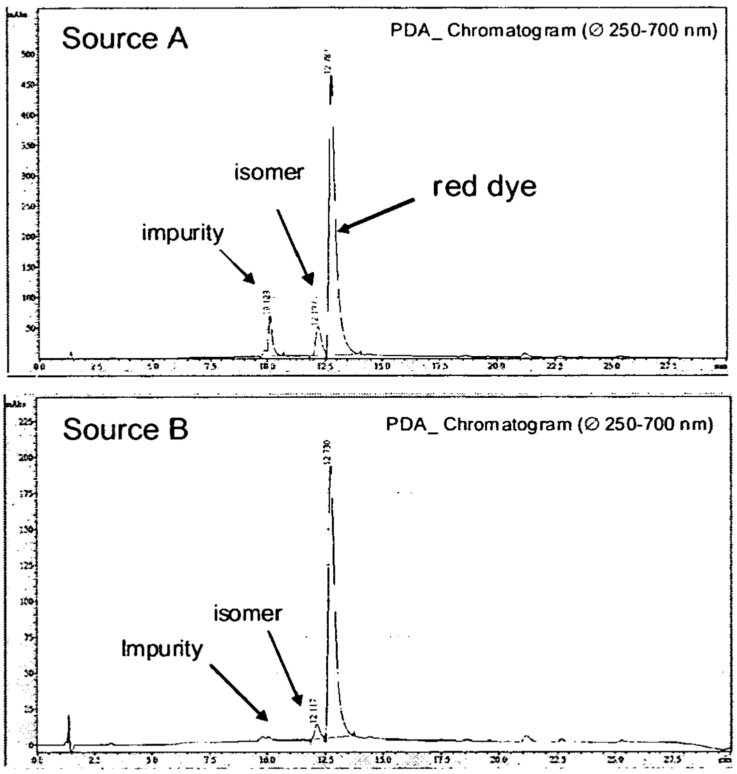


B

| | HPLC - purity | Energy conversion efficiency of DSSC* |
|---|---|---|
| Source A | 90.2 | 5.44 |
| Source B | 95.8 | 7.06 |

*Polymer gel based DSSCs measured with sulphur lamp, 100 $mW/cm^2$

FIGURE 3

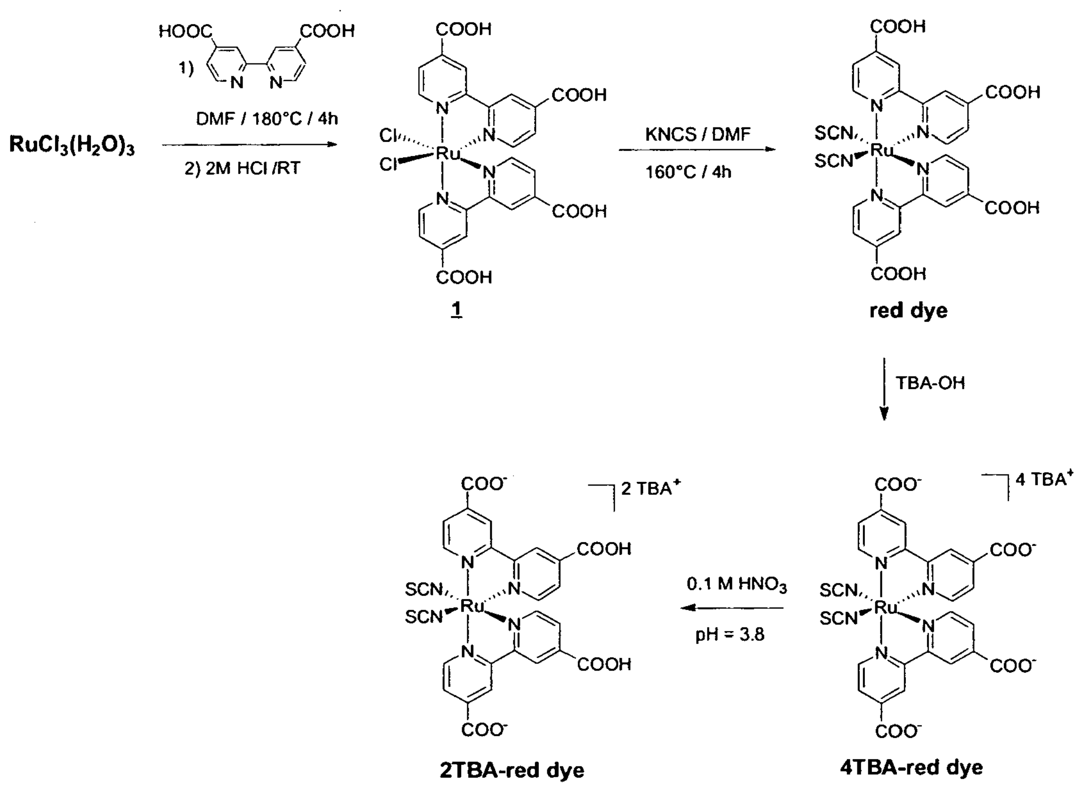
RuCl3(H2O)3
1)
DMF / 180°C / 4h
2) 2M HCl /RT
1
KNCS / DMF
160°C / 4h
red dye
TBA-OH
4 TBA+
4TBA-red dye
0.1 M HNO3
pH = 3.8
2 TBA+
2TBA-red dye

FIGURE 4

A

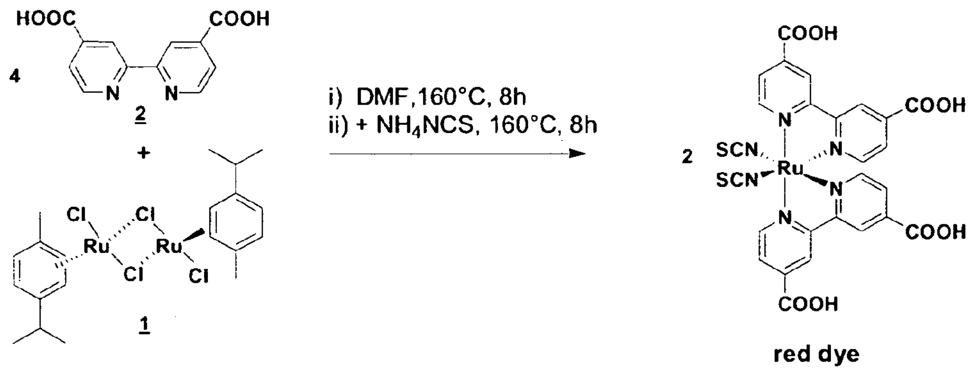


red dye

B

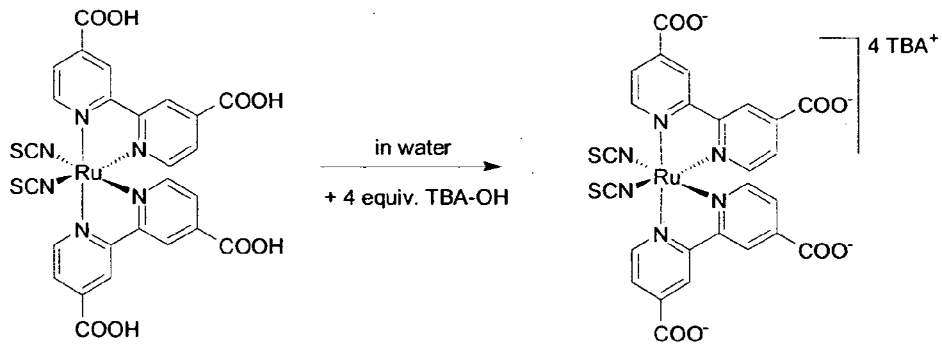


red dye

4TBA-red dye

C

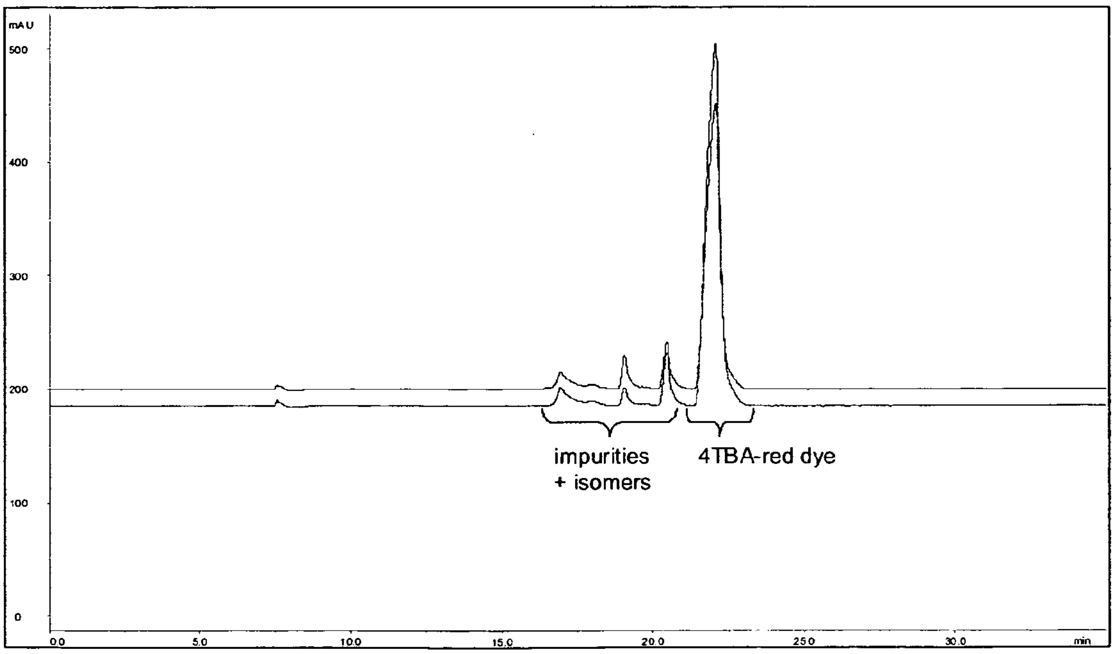


FIGURE 5

D

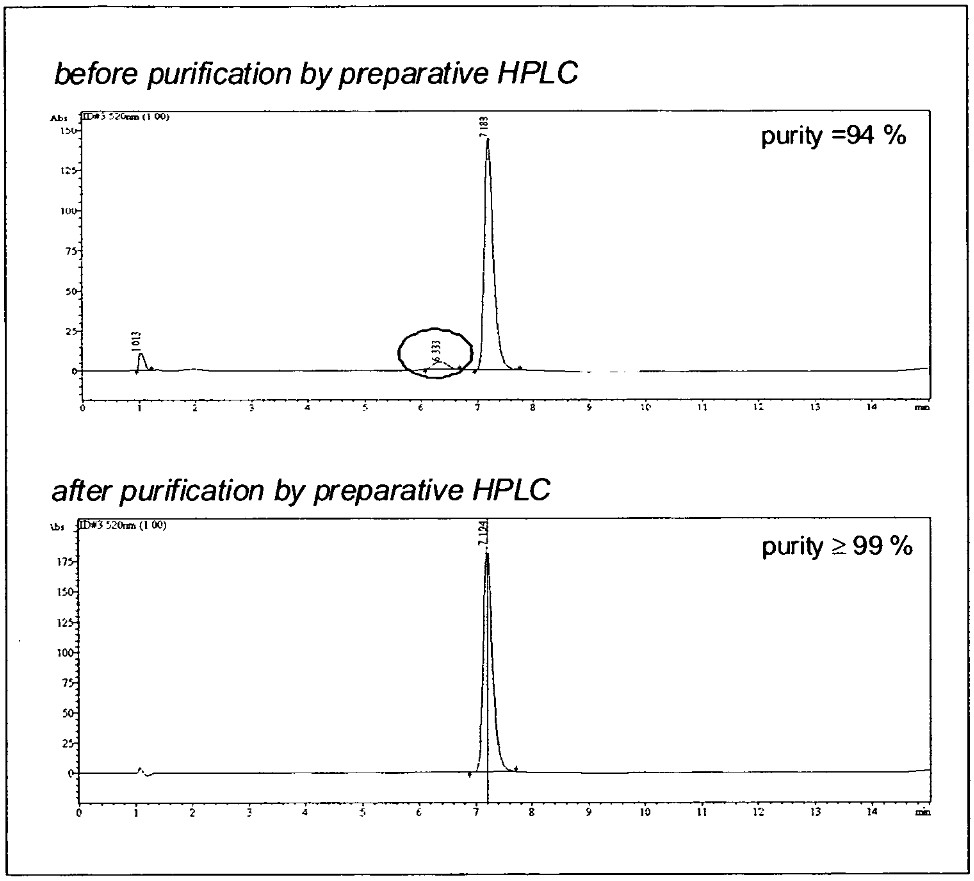


E

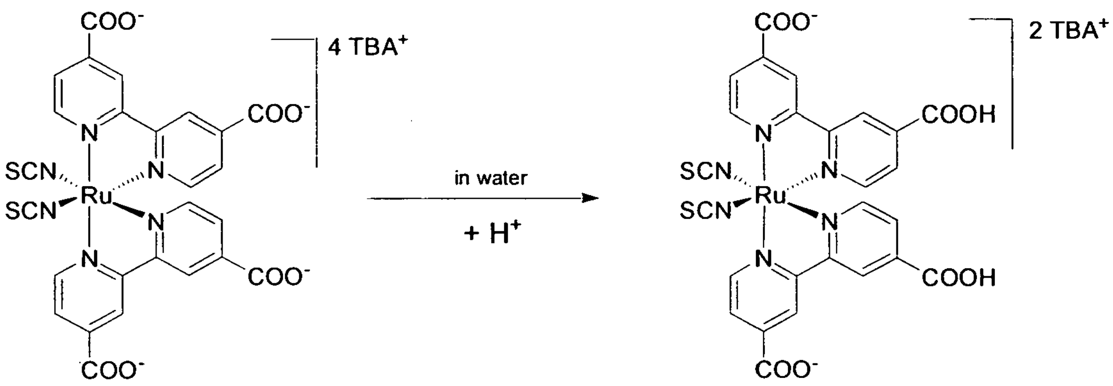


4TBA-red dye

2TBA-red dye

FIGURE 5

A

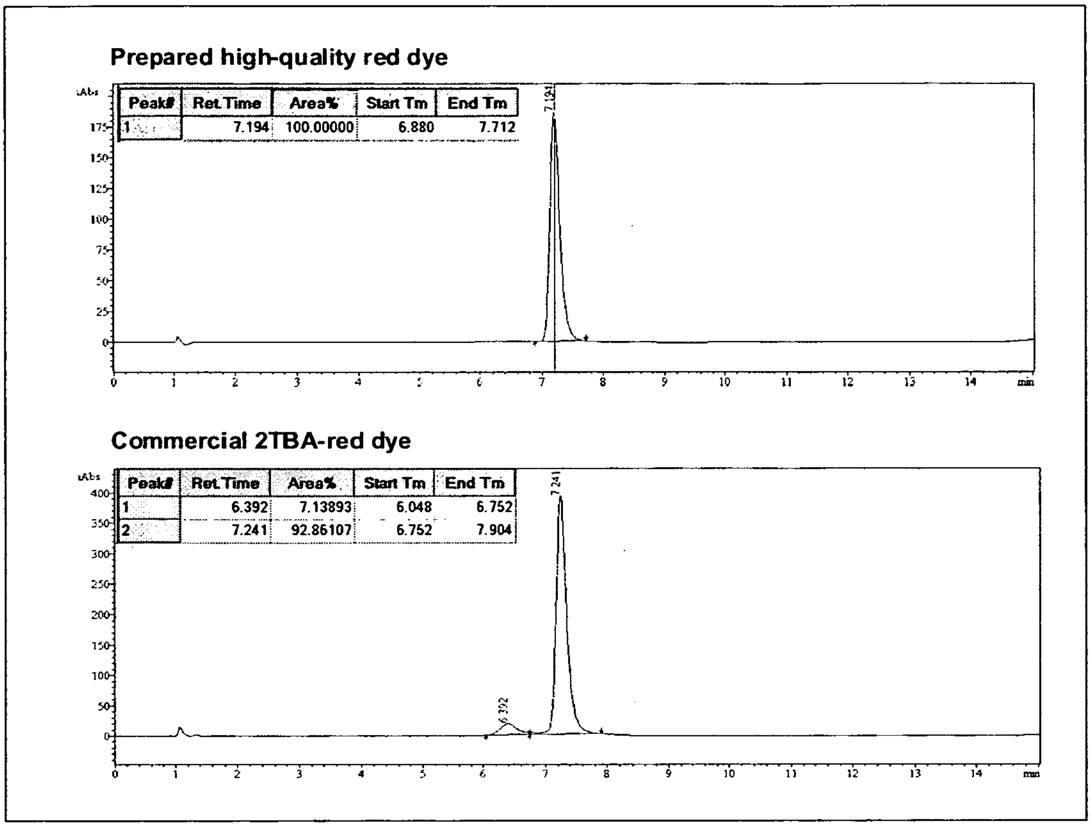
Prepared high-quality red dye
Peak# | Ret.Time | Area% | Start Tm | End Tm
1 | 7.194 | 100.00000 | 6.880 | 7.712
Commercial 2TBA-red dye
Peak# | Ret.Time | Area% | Start Tm | End Tm
1 | 6.392 | 7.13893 | 6.048 | 6.752
2 | 7.241 | 92.86107 | 6.752 | 7.904
min

FIGURE 6

B

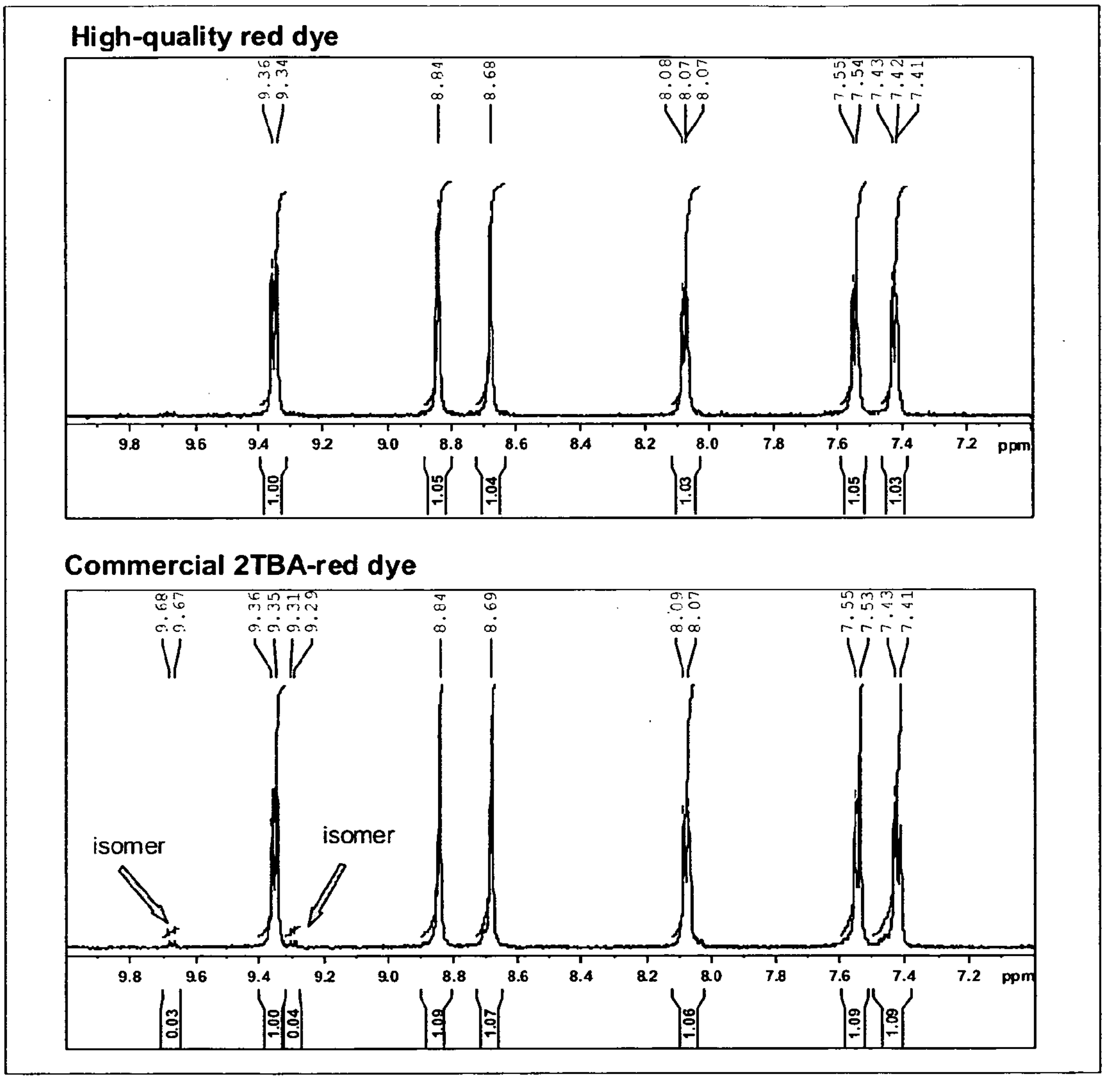
High-quality red dye
9.36
9.34
8.84
8.68
8.08
8.07
8.07
7.55
7.54
7.43
7.42
7.41
9.8 9.6 9.4 9.2 9.0 8.8 8.6 8.4 8.2 8.0 7.8 7.6 7.4 7.2 ppm
1.00
1.05
1.04
1.03
1.05
1.03
Commercial 2TBA-red dye
9.68
9.67
9.36
9.35
9.31
9.29
8.84
8.69
8.09
8.07
7.55
7.53
7.43
7.41
isomer
isomer
9.8 9.6 9.4 9.2 9.0 8.8 8.6 8.4 8.2 8.0 7.8 7.6 7.4 7.2 ppm
0.03
1.00
0.04
1.09
1.07
1.06
1.09
1.09

FIGURE 6

A

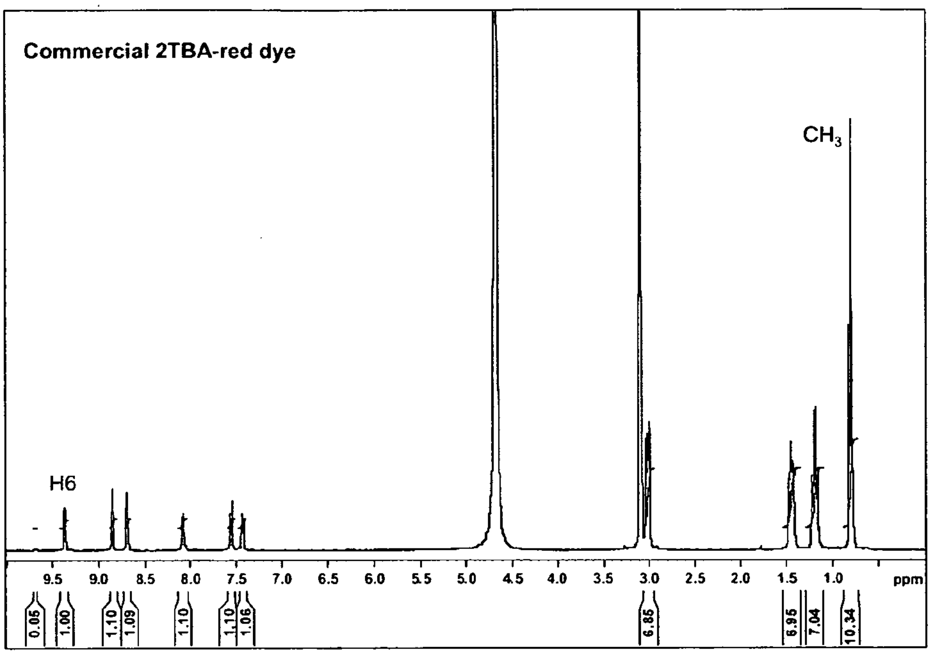
Commercial 2TBA-red dye
CH3
H6
9.5 9.0 8.5 8.0 7.5 7.0 6.5 6.0 5.5 5.0 4.5 4.0 3.5 3.0 2.5 2.0 1.5 1.0 ppm
0.05 1.00 1.10 1.09 1.10 1.10 1.06 6.86 6.95 7.04 10.34

B

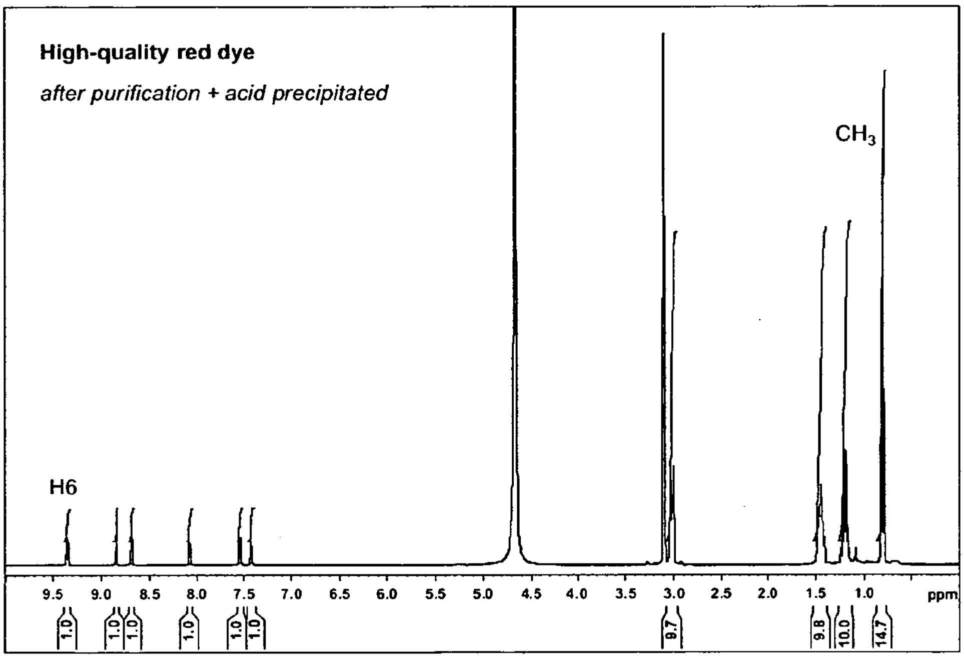
High-quality red dye
after purification + acid precipitated
CH3
H6
9.5 9.0 8.5 8.0 7.5 7.0 6.5 6.0 5.5 5.0 4.5 4.0 3.5 3.0 2.5 2.0 1.5 1.0 ppm
1.0 1.0 1.0 1.0 1.0 1.0 9.7 9.8 10.0 14.7

FIGURE 7

C

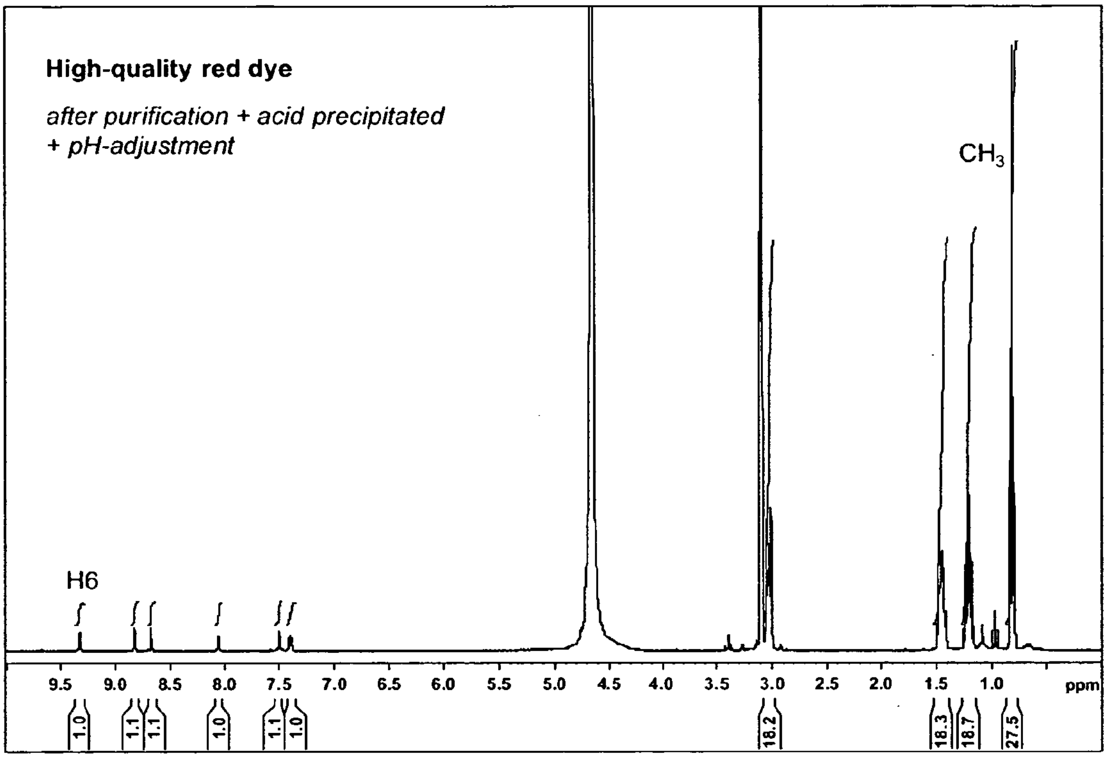


D

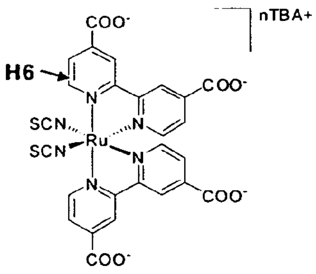

Sensitizer dye

TBA = $N(CH_2\text{-}CH_2\text{-}CH_2\text{-}CH_3)_4$

**Sample:**
**1** commercial 2TBA-red dye
**2** high-quality red dye: after purification + acid precipitation
**3** high-quality red dye : after purification + acid precipitation + pH adjustment

| | | pH of a 0.3 mM dye-solution | |
|---|---|---|---|
| sample | $^1$H NMR- signals ratio **H6**-bipy / **$CH_3$**-TBA | in ethanol | in acetonitrile / t-butanol 1/1 |
| 1 | 1.0 / 10.3 | 5.3 | 7.1 |
| 2 | 1.0 / 14.7 | 5.6 | 7.5 |
| 3 | 1.0 / 27.5 | 6.1 | 8.1 |

FIGURE 7

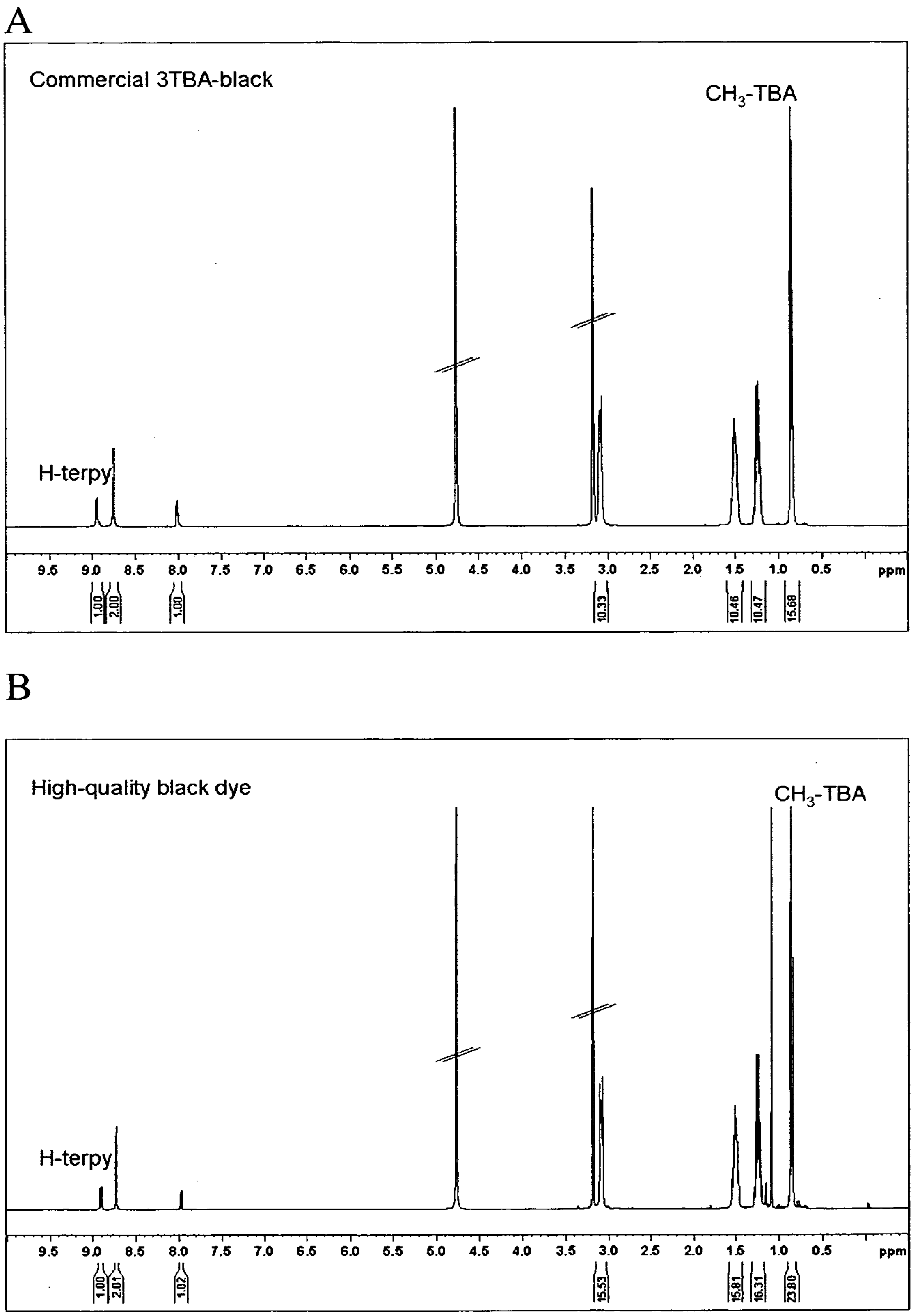
A
Commercial 3TBA-black
CH3-TBA
H-terpy
9.5 9.0 8.5 8.0 7.5 7.0 6.5 6.0 5.5 5.0 4.5 4.0 3.5 3.0 2.5 2.0 1.5 1.0 0.5 ppm
1.00 2.00 1.00 10.33 10.46 10.47 15.68
B
High-quality black dye
CH3-TBA
H-terpy
9.5 9.0 8.5 8.0 7.5 7.0 6.5 6.0 5.5 5.0 4.5 4.0 3.5 3.0 2.5 2.0 1.5 1.0 0.5 ppm
1.00 2.01 1.02 15.53 15.81 16.31 23.80

FIGURE 8

C

H-terpy

$CH_3$-TBA

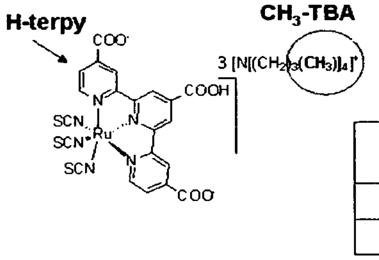

**Sample:**
**1 commercial 3TBA-black dye**
**2 high-quality black dye**

| sample | $^1$H NMR- signals ratio **H-terpy / $CH_3$**-TBA | pH of a 0.3 mM acetonitrile/t-butanol dye-solution |
|---|---|---|
| 1 | 1.0 / 15.7 | 9.1 |
| 2 | 1.0 / 23.8 | 9.6 |

FIGURE 8

A

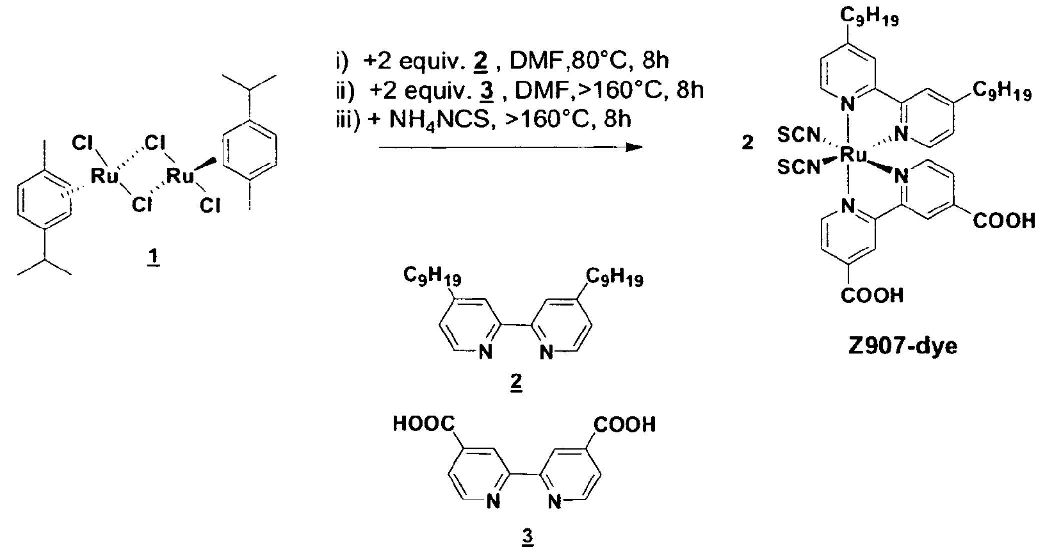


1

2

3

2

Z907-dye

B

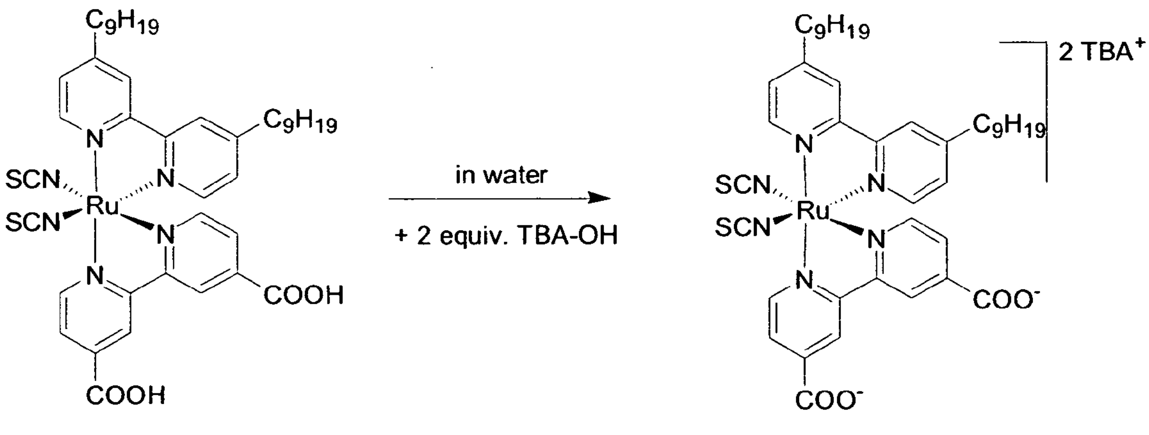


Z907- dye

2TBA-Z907 - dye

FIGURE 9

C

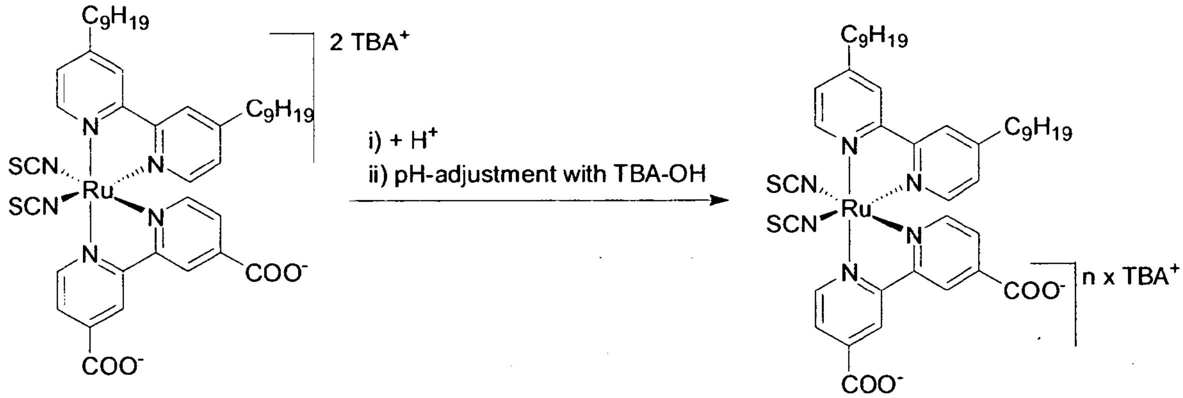


**2TBA-Z907 - dye**

**High-quality Z907- dye**

FIGURE 9

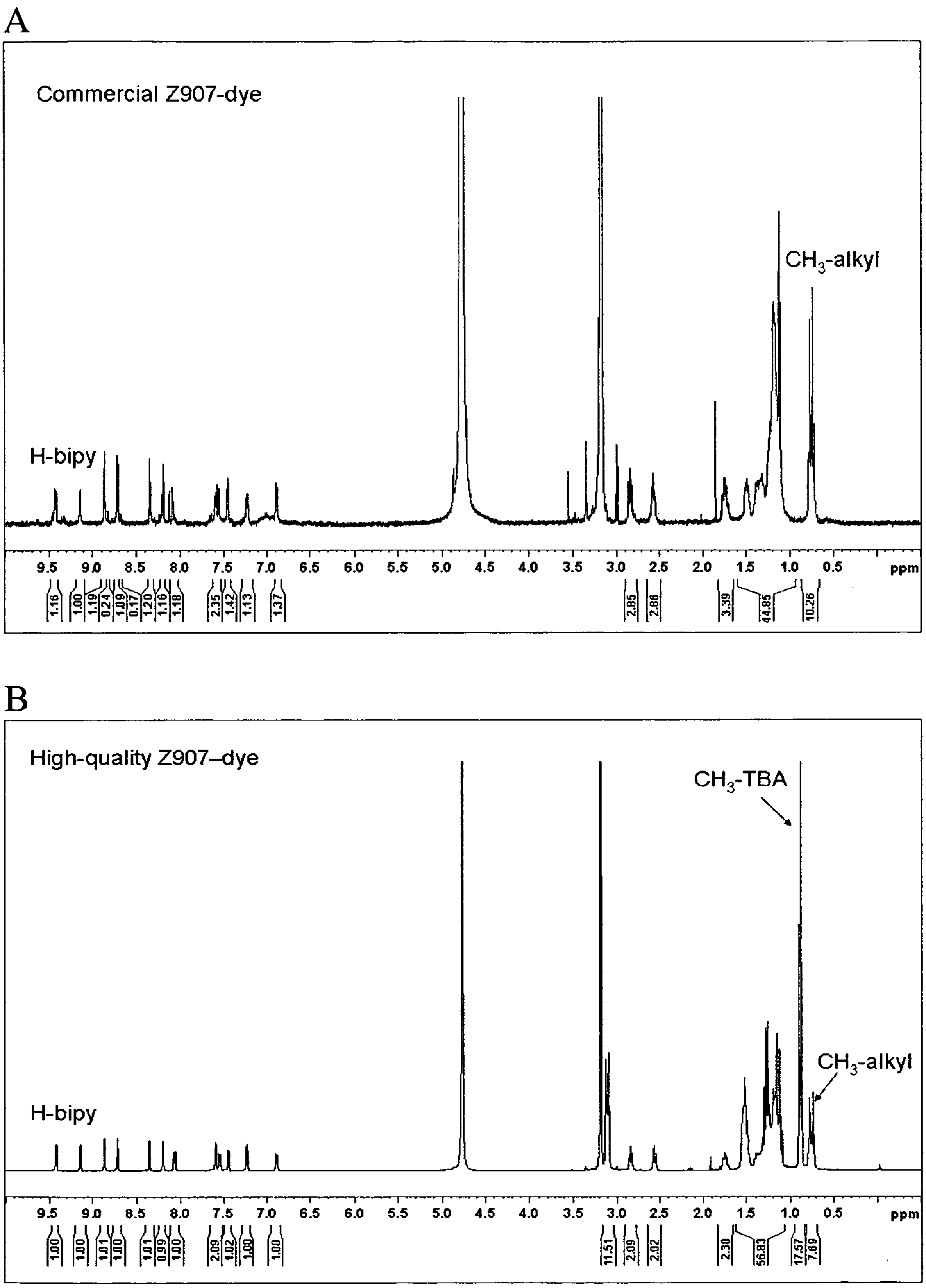
A
Commercial Z907-dye
CH$_3$-alkyl
H-bipy
9.5 9.0 8.5 8.0 7.5 7.0 6.5 6.0 5.5 5.0 4.5 4.0 3.5 3.0 2.5 2.0 1.5 1.0 0.5 ppm
1.16 1.00 1.19 0.24 1.09 0.17 1.20 1.16 1.18 2.35 1.42 1.13 1.37 2.85 2.86 3.39 44.85 10.26
B
High-quality Z907–dye
CH$_3$-TBA
CH$_3$-alkyl
H-bipy
9.5 9.0 8.5 8.0 7.5 7.0 6.5 6.0 5.5 5.0 4.5 4.0 3.5 3.0 2.5 2.0 1.5 1.0 0.5 ppm
1.00 1.00 1.01 1.00 1.01 0.99 1.00 2.09 1.02 1.00 1.00 11.51 2.09 2.02 2.30 56.83 17.57 7.89
Figure 10

C

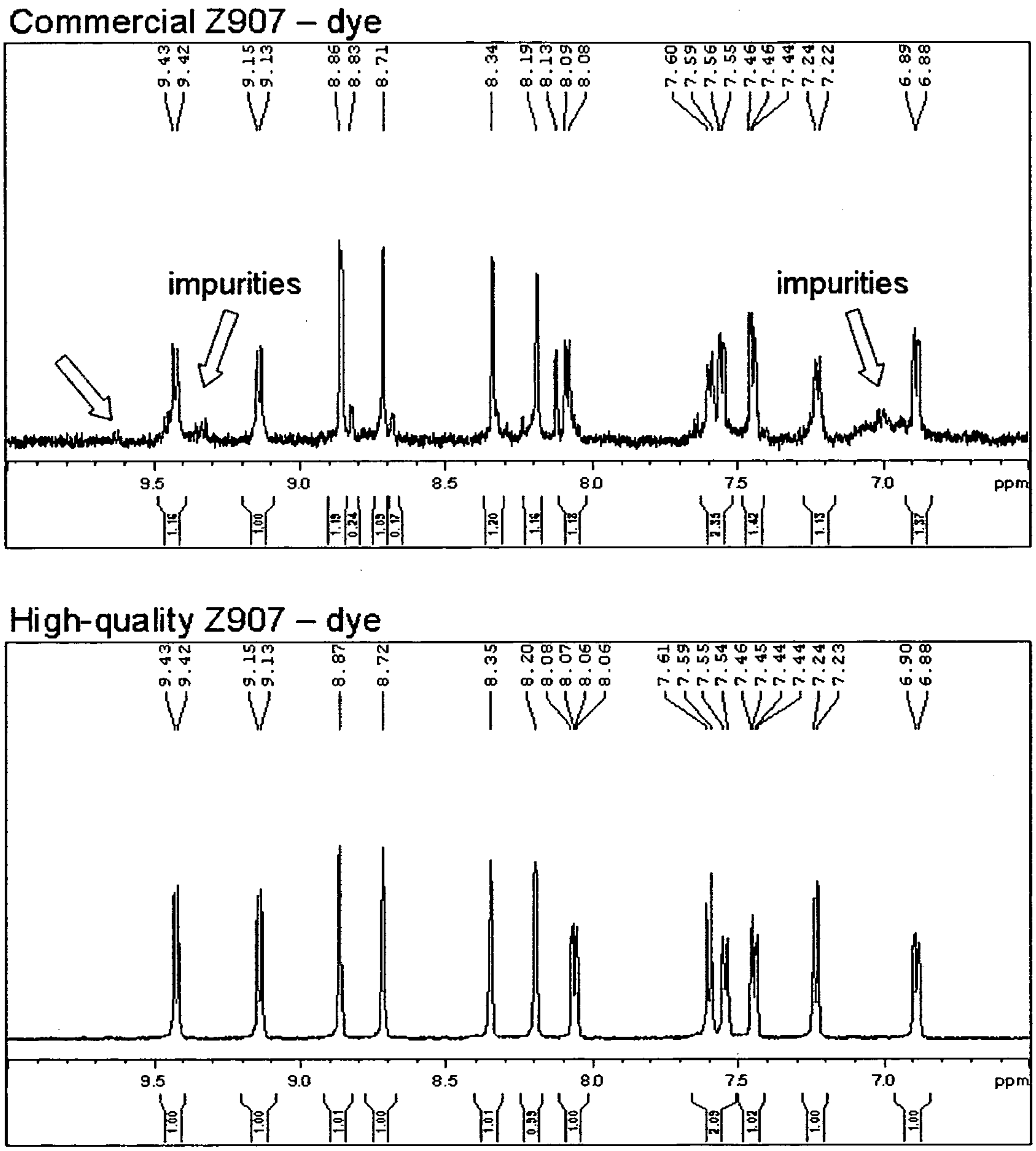
Commercial Z907 – dye
impurities
impurities
9.5
9.0
8.5
8.0
7.5
7.0
ppm
High-quality Z907 – dye
9.5
9.0
8.5
8.0
7.5
7.0
ppm

Figure 10

D

H-bipy

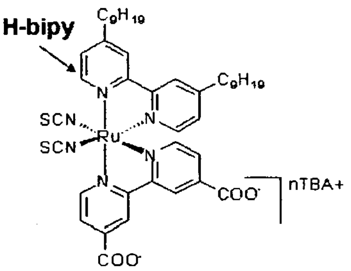

Sensitizer dye

TBA = $N(CH_2-CH_2-CH_2-CH_3)_4$

CH3-TBA

**Sample:**
**1** commercial Z907 dye
**2** high-quality Z907 dye

| sample | $^1$H NMR- signals ratio H-bipy / $CH_3$-TBA | pH of a 0.3 mM acetonitrile/t-butanol (1/1)dye-solution |
|---|---|---|
| 1 | no TBA | 6.6 |
| 2 | 1.0 / 17.5 | 7.6 |

Figure 10

Europäisches Patentamt
European Patent Office
Office européen des brevets

# EUROPEAN SEARCH REPORT

Application Number
EP 08 00 7771

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ASHRAFUL ISLAM ET AL: "Sensitization of nanocrystalline TiO2 film by ruthenium(II) diimine dithiolate complexes" JOURNAL OF PHOTOCHEMISTRY AND PHOTOBIOLOGY, A: CHEMISTRY, ELSEVIER SEQUOIA, LAUSANNE, CH, vol. 145, 1 January 2001 (2001-01-01), pages 135-141, XP007903939 ISSN: 1010-6030 * page 136 * ----- | 1-21, 25-35 | INV. H01L51/00<br>ADD. H01G9/20 |
| X | MITSOPOULOU ET AL: "Synthesis, characterization and sensitization properties of two novel mono and bis carboxyl-dipyrido-phenazine ruthenium(II) charge transfer complexes" JOURNAL OF PHOTOCHEMISTRY AND PHOTOBIOLOGY, A: CHEMISTRY, ELSEVIER SEQUOIA, LAUSANNE, CH, vol. 191, no. 1, 8 August 2007 (2007-08-08), pages 6-12, XP022190764 ISSN: 1010-6030 * pages 7-8 * ----- | 1-21, 25-35 | TECHNICAL FIELDS SEARCHED (IPC)<br>H01L |
| A | CHEN M ET AL: "Purification and identification of several sulphonated azo dyes using reversed-phase preparative high-performance liquid chromatography" JOURNAL OF CHROMATOGRAPHY, ELSEVIER SCIENCE PUBLISHERS B.V. AMSTERDAM, NL, vol. 825, no. 1, 30 October 1998 (1998-10-30), pages 37-44, XP004141940 ISSN: 0021-9673 * the whole document * ----- -/-- | 1 | |

~~The present search report has been drawn up for all claims~~

| Place of search | Date of completion of the search | Examiner |
|---|---|---|
| The Hague | 6 October 2008 | Wolfbauer, Georg |

2

EPO FORM 1503 03.82 (P04C01)

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

Europäisches Patentamt
European Patent Office
Office européen des brevets

# EUROPEAN SEARCH REPORT

Application Number
EP 08 00 7771

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 99/03868 A (JOHNSON MATTHEY PLC [GB]; ECOLE POLYTECH [CH]; MURRER BARRY ANTHONY [G) 28 January 1999 (1999-01-28)<br>* examples 1,4 *<br>----- | 1 | |
| A | R.E. SHEPHERD: "Chromatographic and related electrophoretic methods in the separation of transition metal complexes or their ligands"<br>COORDINATION CHEMISTRY REVIEW,<br>vol. 247, 2003, pages 147-184, XP007905853<br>* pages 150-151 *<br>* pages 154-155 *<br>----- | 1 | |

TECHNICAL FIELDS SEARCHED (IPC)

~~The present search report has been drawn up for all claims~~

2

| Place of search | Date of completion of the search | Examiner |
|---|---|---|
| The Hague | 6 October 2008 | Wolfbauer, Georg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches Patentamt
European Patent Office
Office européen des brevets

Application Number

EP 08 00 7771

## CLAIMS INCURRING FEES

The present European patent application comprised at the time of filing claims for which payment was due.

- [ ] Only part of the claims have been paid within the prescribed time limit. The present European search report has been drawn up for those claims for which no payment was due and for those claims for which claims fees have been paid, namely claim(s):

- [ ] No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

- [ ] All further search fees have been paid within the fixed time limit. The present European search report has been drawn up for all claims.

- [ ] As all searchable claims could be searched without effort justifying an additional fee, the Search Division did not invite payment of any additional fee.

- [ ] Only part of the further search fees have been paid within the fixed time limit. The present European search report has been drawn up for those parts of the European patent application which relate to the inventions in respect of which search fees have been paid, namely claims:

- [X] None of the further search fees have been paid within the fixed time limit. The present European search report has been drawn up for those parts of the European patent application which relate to the invention first mentioned in the claims, namely claims:

  1-21, 25-35

- [ ] The present supplementary European search report has been drawn up for those parts of the European patent application which relate to the invention first mentioned in the claims (Rule 164 (1) EPC).

Europäisches Patentamt
European Patent Office
Office européen des brevets

## LACK OF UNITY OF INVENTION SHEET B

Application Number
EP 08 00 7771

The Search Division considers that the present European patentapplication does not comply with the requirements of unity of invention and relates to severalinventions or groups of inventions, namely:

1. claims: 1-21,25-35

   A method of purifying a dye by reversed-phase chromatography

   ---

2. claims: 22-25

   A one pot synthesis method for synthesizing a ruthenium dye

   ---

## ANNEX TO THE EUROPEAN SEARCH REPORT ON EUROPEAN PATENT APPLICATION NO. EP 08 00 7771

This annex lists the patent family members relating to the patent documents cited in the above-mentioned European search report.
The members are as contained in the European Patent Office EDP file on
The European Patent Office is in no way liable for these particulars which are merely given for the purpose of information.

06-10-2008

| Patent document cited in search report | Publication date | Patent family member(s) | Publication date |
|---|---|---|---|
| WO 9903868 A | 28-01-1999 | AU 734412 B2 | 14-06-2001 |
| | | AU 8224298 A | 10-02-1999 |
| | | EP 0998481 A1 | 10-05-2000 |
| | | JP 2001510199 T | 31-07-2001 |
| | | ZA 9806323 A | 02-02-1999 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 02092569 A1
- WO 9116719 A, Grätzel
- WO 9404497 A


### Non-patent literature cited in the description


- **O'Regan B. ; Grätzel M.** *Nature,* 1991, vol. 353, 737
- **Nazeeruddin M.K. et al.** *J. Am. Chem. Soc.,* 1993, vol. 115, 6382-6290
- **Nazeeruddin et al.** *Inorg. Chem.,* 1999, vol. 28, 6298-6305
- **M.K. Nazeeruddin et al.** *J. Am. Chem. Soc.,* 2001, vol. 123, 1613-1624